# EUROPEAN PATENT APPLICATION

(11) **EP 4 838 001 A1**
(43) Date of publication of application: **11.11.2026**
(21) Application number: 24960022.2
(22) Date of filing: 11.11.2024
(51) Int. Cl.: C30B 23/00

(54) **CRYSTAL GROWTH DEVICE**

(71) Applicant: BOYA ADVANCED MATERIALS CO., LTD., Meishan, Sichuan 620010 (CN)
(72) Inventor: WANG, Yu, Sichuan 620010 (CN); YUAN, Li, Chengdu, Sichuan 610200 (CN); LEI, Pei, Chengdu, Sichuan 610200 (CN); FU, Jun, Sichuan 620010 (CN); GU, Peng, Sichuan 620010 (CN)
(74) Representative: Wang, Bo
(86) International application number: PCT/CN2024/131197
(87) International publication number: WO 2026/097558

(57) **Abstract**

An apparatus for crystal growth is provided. The apparatus comprises a furnace body, a crucible, and a heating assembly. The furnace body comprises a furnace chamber, and the crucible and the heating assembly are both arranged in the furnace chamber.

## Description

### TECHNICAL FIELD

The present disclosure generally relates to the field of crystal growth, and in particular to an apparatus for crystal growth.

### BACKGROUND

A physical vapor transport (PVT) method refers to a method for preparing a semiconductor crystal. During a semiconductor crystal growth process, an axial temperature gradient is formed between a material and a seed crystal by controlling a temperature field distribution in a growth cavity (e.g., a crucible). The material is decomposed and sublimated into a gas phase component under a high temperature condition, and the gas phase component is transported to the seed crystal in a low temperature region driven by the axial temperature gradient and deposited on a surface of the seed crystal to generate a crystal.

### SUMMARY

One or more embodiments of the present disclosure provide an apparatus for crystal growth. The apparatus includes a furnace body, a crucible, and a heating assembly. The furnace body comprises a furnace chamber, the crucible and the heating assembly are both disposed within the furnace chamber, and the heating assembly is configured to heat the crucible.

In some embodiments, the heating assembly comprises at least one of a first heating assembly or a second heating assembly, wherein the first heating assembly heats a bottom of the crucible; and the second heating assembly heats a side of the crucible.

In some embodiments, the second heating assembly comprises a second induction coil; the second induction coil is arranged around a sidewall of the crucible; the first heating assembly comprises a first induction coil, and the first induction coil is arranged around a bottom wall of the crucible; or, the first heating assembly comprises a first resistance heater, and the first heating assembly is arranged below the bottom wall of the crucible.

In some embodiments, a graphite ring is arranged at a bottom of the crucible, and the first induction coil is at least partially arranged around an outside of the graphite ring; or the first resistance heater is embedded inside the bottom wall of the crucible.

In some embodiments, an annular baffle is arranged between the first induction coil and the second induction coil, and the annular baffle is arranged around the crucible.

In some embodiments, the heating assembly further comprises a third heating assembly, and the third heating assembly heats a top of the crucible.

In some embodiments, the third heating assembly comprises a second resistance heater.

In some embodiments, a distance between the first resistance heater and the crucible, and a distance between the second resistance heater and the crucible are both greater than 20 mm; and/or, at least one of the first resistance heater or the second resistance heater comprises resistance wires, and a minimum interval distance between the resistance wires is within a range of 10 mm-15 mm.

In some embodiments, during a crystal growth stage, a ratio of bottom heat to side heat obtained by a material in the crucible is 1-4, and a ratio of side heat to top heat is 1-3; during an annealing stage, a ratio of top heat to side heat obtained by the material in the crucible is within a range of 1.5-5, wherein the bottom heat is provided by the first heating assembly, the side heat is provided by the second heating assembly, and the top heat is provided by the third heating assembly.

In some embodiments, the second heating assembly further comprises a third induction coil, and the third induction coil is sleeved on an outside of the second induction coil.

In some embodiments, a power of the first induction coil is greater than a power of the second induction coil.

In some embodiments, the apparatus further comprises: a first induction coil moving mechanism, configured to drive the second induction coil to move along an axial direction of the crucible, the first induction coil moving mechanism being connected to the second induction coil; and a second induction coil moving mechanism, configured to drive the third induction coil to move along the axial direction of the crucible, the second induction coil moving mechanism being connected to the third induction coil.

In some embodiments, the apparatus further comprises a fourth induction coil and a fifth induction coil, the fourth induction coil being arranged below the second induction coil in the axial direction of the crucible; the fifth induction coil is sleeved on an outside of the fourth induction coil, and the fifth induction coil is arranged below the third induction coil in the axial direction of the crucible.

In some embodiments, the apparatus further comprises a filtering structure arranged in the furnace chamber, the filtering structure being located above a material in the crucible in the axial direction of the crucible, wherein the filtering structure comprises through-holes penetrating the filtering structure from top to bottom along the axial direction of the crucible.

In some embodiments, a material of the filtering structure comprises graphite; or the material of the filtering structure comprises one or more of tantalum, tungsten, titanium, and corresponding nitrides or carbides.

In some embodiments, a through-hole in a central region of the filtering structure has a larger aperture size and a smaller porosity, and a through-hole in an edge region of the filtering structure has a smaller aperture size and a larger porosity.

In some embodiments, a porosity of the filtering structure is within a range of 5%-40%.

In some embodiments, the furnace chamber comprises a plurality of chambers, and the apparatus for crystal growth includes a plurality of crucibles, the plurality of crucibles being respectively arranged in the plurality of chambers; the apparatus for crystal growth further comprises a conveying mechanism, at least a part of the conveying mechanism being located in the furnace chamber, the plurality of chambers being arranged along a conveying direction of the conveying mechanism, and the conveying mechanism conveys the plurality of crucibles to move the plurality of crucibles between different chambers.

In some embodiments, the number of the chambers is at least three; a crystal growth process comprises a preheating stage, a crystal growth stage, and an annealing stage, at least a portion of the chambers having a temperature range of the preheating stage forms a first chamber, at least a portion of the chambers having a temperature range of the crystal growth stage forms a second chamber, and at least a portion of the chambers having a temperature range of the annealing stage forms a third chamber; the first chamber, the second chamber, and the third chamber are arranged along the conveying direction.

In some embodiments, a passage and an openable partition are arranged between two adjacent chambers.

In some embodiments, the heating assembly comprises a plurality of sixth induction coils and a plurality of coil lifting devices, the plurality of sixth induction coils and the plurality of coil lifting devices are respectively arranged in the plurality of chambers, the plurality of coil lifting devices are connected to the plurality of sixth induction coils in a one-to-one correspondence, and the coil lifting device is capable of lifting the sixth induction coil along the axial direction of the crucible.

In some embodiments, the apparatus further comprises a plurality of thermal insulation structures, the plurality of thermal insulation structures being arranged outside the plurality of crucibles in a one-to-one correspondence; each thermal insulation structure comprises a side insulating part and a top insulating part, and a temperature measuring opening is arranged on the top insulating part.

In some embodiments, the apparatus for crystal growth comprises a first temperature measuring assembly, the first temperature measuring assembly comprising a first electrical rail and a plurality of first thermometers, the plurality of first thermometers respectively measuring temperatures in inner cavities of the plurality of crucibles, the first electrical rail being arranged outside the crucibles, and a portion of each first thermometer of the plurality of first thermometers extending out of the crucible is in sliding electrical contact with the first electrical rail, the first electrical rail being parallel to the conveying direction of the conveying mechanism.

In some embodiments, the apparatus for crystal growth further comprises a plurality of third resistance heaters, the plurality of third resistance heaters being respectively arranged in the plurality of chambers and located at bottoms of the plurality of crucibles, and the plurality of third resistance heaters are arranged below the conveying mechanism in the axial direction of the crucible.

In some embodiments, the apparatus further comprises a material preparation assembly, the material preparation assembly comprising a tunnel furnace and a plurality of raw material furnaces; the tunnel furnace comprises a heating chamber and a movement driving mechanism, the plurality of raw material furnaces being sequentially arranged in the heating chamber along a length direction of the tunnel furnace, and the movement driving mechanism drives the plurality of raw material furnaces to move along the length direction of the tunnel furnace; a fourth heating assembly is arranged in the heating chamber, and the fourth heating assembly is configured to heat the raw material furnace.

In some embodiments, the tunnel furnace further comprises an insulating layer, the insulating layer insulating the heating chamber.

In some embodiments, the tunnel furnace further comprises a cooling mechanism, the cooling mechanism being arranged outside the heating chamber.

In some embodiments, the heating chamber sequentially comprises a preheating section, a heating section, and a cooling section along the length direction of the tunnel furnace; each of the preheating section, the heating section, and the cooling section is provided with a first temperature measuring mechanism and a first pressure measuring mechanism.

In some embodiments, the tunnel furnace comprises a second temperature measuring assembly, the second temperature measuring assembly being capable of measuring a temperature in each of the raw material furnaces.

In some embodiments, the second temperature measuring assembly comprises a second electrical rail and a plurality of second thermometers, the plurality of second thermometers respectively measuring temperatures in the plurality of raw material furnaces, the second electrical rail being arranged outside the raw material furnaces, and a portion of each second thermometer of the plurality of second thermometers extending out of the raw material furnace is in sliding electrical contact with the second electrical rail, the second electrical rail being parallel to the length direction of the tunnel furnace.

In some embodiments, the plurality of raw material furnaces are connected in sequence, and the movement driving mechanism comprises a push rod or a pull rod, the push rod or the pull rod being connected to one raw material furnace of the plurality of raw material furnaces.

In some embodiments, the apparatus further comprises at least one of a mixing chamber, a compacting chamber, or a pre-vacuum chamber.

In some embodiments, the mixing chamber comprises at least one of a pressure relief device or a weighing device.

In some embodiments, the raw material furnace comprises a main body of the raw material furnace and an upper cover, and the upper cover is provided with a seed crystal bonding surface.

In some embodiments, a plurality of the fourth heating assemblies are provided, the plurality of fourth heating assemblies are respectively disposed around the plurality of raw material furnaces, and a second temperature measuring mechanism and a second pressure measuring mechanism are provided on each raw material furnace.

One of the embodiments of the present disclosure provides a method for crystal growth, using the apparatus for crystal growth described above, a crystal growth process comprises a crystal growth stage and an annealing stage, and the method comprises: in the crystal growth stage, heating the crucible through a first heating assembly and a second heating assembly; and in the annealing stage, heating the crucible through a second heating assembly and a third heating assembly.

### BRIEF DESCRIPTION OF THE DRAWINGS

The present disclosure will be further illustrated by way of exemplary embodiments, and these exemplary embodiments will be described in detail by the accompanying drawings. These embodiments are not limiting, and in these embodiments, like numerals represent like structures, wherein:
FIG. 1 is a block diagram illustrating an apparatus for crystal growth according to some embodiments of the present disclosure;
FIG. 2 is a schematic diagram of an apparatus for crystal growth according to some embodiments of the present disclosure;
FIG. 3 is a schematic diagram illustrating a resistance heater according to some embodiments of the present disclosure;
FIG. 4 is a schematic layout diagram of a first induction coil according to some embodiments of the present disclosure;
FIG. 5 is a schematic diagram illustrating an arrangement of a first induction coil and a second induction coil according to some embodiments of the present disclosure;
FIG. 6A is a schematic diagram illustrating an exemplary second heating assembly according to some embodiments of the present disclosure;
FIG. 6B is a schematic diagram illustrating a second heating assembly and a first induction coil moving mechanism according to some embodiments of the present disclosure;
FIG. 7 is a diagram illustrating an axial temperature gradient in the inner cavity of the crucible at different positions;
FIG. 8 is a diagram illustrating the axial temperature distribution in the inner cavity of the crucible at different positions;
FIG. 9 is a diagram illustrating an axial temperature distribution in the inner cavity of the crucible corresponding to the third induction coil at different powers;
FIG. 10 is a bar chart of temperature differences between a seed crystal and a material surface corresponding to different powers of a third induction coil;
FIG. 11A is a schematic diagram illustrating another exemplary second heating assembly according to some embodiments of the present disclosure;
FIG. 11B is a diagram illustrating an axial temperature distribution of the inner cavity of the crucible corresponding to a fourth induction coil and a fifth induction coil at different powers;
FIG. 11C is a bar chart of temperature differences between a seed crystal and a material surface corresponding to different powers of a fourth induction coil and a fifth induction coil;
FIG. 12 is a schematic diagram illustrating an apparatus for crystal growth according to other embodiments of the present disclosure;
FIG. 13 is a schematic diagram of an apparatus for crystal growth according to yet some other embodiments of the present disclosure;
FIG. 14 is a schematic diagram illustrating a filtering structure according to some embodiments of the present disclosure;
FIG. 15A is a schematic diagram of an apparatus for crystal growth according to yet some other embodiments of the present disclosure;
FIG. 15B is a schematic diagram of an apparatus for crystal growth according to yet some other embodiments of the present disclosure;
FIG. 16 is a schematic diagram illustrating a material preparation assembly according to some embodiments of the present disclosure;
FIG. 17 is a schematic diagram of a raw material furnace according to some embodiments of the present disclosure.

Reference numeral description: 100. Apparatus for crystal growth; 110. Furnace body; 111. First chamber; 112. Second chamber; 113. Third chamber; 114. Partition; 120. Crucible; 130. Heating assembly; 121. Upper cover; 122. Main body; 131. First heating assembly; 1311. First resistance heater; 13111. Resistance wire; 1312. First induction coil; 132. Second heating assembly; 1321. Second induction coil; 1322. Third induction coil; 1323. Fourth induction coil; 1324. Fifth induction coil; 133. Graphite ring; 134. Annular baffle; 135. Third heating assembly; 1351. Second resistance heater; 136. Third resistance heater; 137. Sixth induction coil; 140. Material; 150. Filtering structure; 151. Through-hole; 160. Thermal insulation structure; 161. Top insulating part; 162. Side insulating part; 163. Temperature measuring opening; 170. Conveying mechanism; 180. First temperature measuring assembly; 181. First electrical rail; 182. First thermometer; 190. Material preparation assembly; 191. Tunnel furnace; 1911. Heating chamber; 19111. Preheating section; 19112. Heating section; 19113. Cooling section; 1912. Movement driving mechanism; 19121. Push rod; 1913. Insulating layer; 1914. Compacting chamber; 1915. Pre-vacuum chamber; 1916. Mixing chamber; 192. Raw material furnace; 1921. Main body of the raw material furnace; 1922. Upper cover; 1923. Seed crystal bonding surface; 1924. Fourth heating assembly; 60. First induction coil moving mechanism; 61. Suspension rod; 62. Driving member; 200. Seed crystal.

### DETAILED DESCRIPTION

In order to more clearly illustrate technical solutions of the embodiments of the present disclosure, the figures to be used in the description of the embodiments are briefly introduced hereinafter. It is apparent that the figures in the following description are merely some examples or embodiments of the present disclosure. For a person of ordinary skill in the art, without making inventive efforts, the present disclosure may also be applied to other similar scenarios based on the figures. Unless it is apparent from the context or otherwise specified, like reference numerals in the figures represent the same structures or operations.

As shown in the present disclosure and the claims, unless the context clearly indicates exceptions, words such as 'a', 'an', 'one', and/or 'the' do not specifically refer to the singular, but may also include the plural. Generally speaking, the terms 'comprising' and 'including' merely suggest the inclusion of expressly identified steps and elements, and these steps and elements do not constitute an exclusive list; a manner or an apparatus may also include other steps or elements. The term 'based on' refers to 'at least partially based on'. The term 'an embodiment' refers to 'at least one embodiment'; the term 'another embodiment' refers to 'at least one additional embodiment'.

It should be understood that the terms 'system', 'apparatus', 'unit ', and/or 'module' as used herein are a manner configured to distinguish different components, elements, parts, portions, or assemblies at different levels. However, if other words can achieve the same purpose, the words may be replaced by other expressions.

The words 'first', 'second', and similar words used in the present disclosure and the claims do not indicate any order, quantity, or importance, but are merely used to distinguish different components. Similarly, similar words such as 'a' or 'one' do not indicate a quantity limitation, but indicate the presence of at least one. In the description of the present disclosure, the term 'a plurality of' refers to at least two (e.g., two, three, or the like), unless otherwise expressly and specifically limited.

Unless otherwise indicated, similar terms such as 'top', 'bottom', 'side', 'lower portion', and/or 'upper portion' are used for ease of description and are not limited to any particular position or spatial orientation. Generally speaking, the terms 'comprising' and 'including' merely suggest the inclusion of expressly identified steps and elements, and these steps and elements do not constitute an exclusive list; a manner or an apparatus may also include other steps or elements.

Flowcharts are used in the present disclosure to illustrate operations performed by a system according to embodiments of the present disclosure. It should be understood that the preceding or succeeding operations are not necessarily executed precisely in sequence. Conversely, the steps may be processed in reverse order or simultaneously. Meanwhile, other operations may be added to these processes, or one or more steps may be removed.

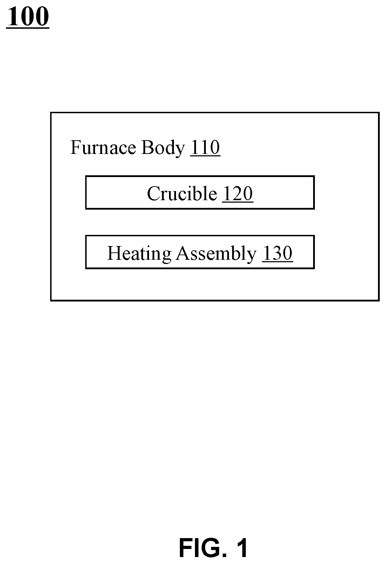

FIG. 1 is a block diagram illustrating an apparatus for crystal growth according to some embodiments of the present disclosure. As shown in FIG. 1, the apparatus for crystal growth 100 comprises a furnace body 110, a crucible 120, and a heating assembly 130. The heating assembly 130 is configured to heat the crucible 120.

The apparatus for crystal growth 100 may be configured to prepare crystals. In some embodiments, the apparatus for crystal growth 100 may prepare crystals based on a Physical Vapor Transport (PVT) manner. In some embodiments, the crystals may include but are not limited to silicon carbide crystals, aluminum nitride crystals, zinc oxide crystals, or zinc antimonide crystals.

The furnace body 110 refers to a structure configured to accommodate the crucible 120 and the heating assembly 130. In some embodiments, the furnace body 110 comprises a furnace chamber, and the crucible 120 and the heating assembly 130 are both disposed within the furnace chamber.

The crucible 120 refers to a place for crystal growth. In some embodiments, the crucible 120 comprises an inner cavity and a wall body that surrounds and forms the inner cavity, and the material 140 is accommodated within the inner cavity of the crucible 120. In some embodiments, a material of the crucible 120 may include but is not limited to graphite. In some embodiments, the material of the crucible 120 may include graphite and SiC. In some embodiments, a proportion of a mass of graphite in a mass of the crucible 120 may be one of 40%-90%, 45%-85%, 50%-80%, 55%-75%, 60%-70%, 64%-66%, or the like. In some embodiments, the shape of the crucible 120 may include, but is not limited to, a regular shape or an irregular shape, such as a cylindrical shape, a cuboid, or the like. For ease of description, the crucible 120 is described as being cylindrical. The crucible 120 has an axial direction extending along a central axis. In the axial direction, the crucible 120 has two ends: one end is the top, the end opposite the top is the bottom, and the portion between the top and the bottom is the side.

In some embodiments, the crucible 120 may include an upper cover 121 and a main body 122. The main body 122 may include the wall body that surrounds and forms the inner cavity as described above, and the inner cavity is formed within the main body 122. The upper cover 121 may be located at the top portion of the main body 122, and is configured to close a top opening of the main body 122.

In some embodiments, the shape of the main body 122 may include but is not limited to a cylindrical shape, a cuboid, a cube, or the like. In some embodiments, the shape of the upper cover 121 may include but is not limited to a circular disk, a rectangular disk, a square disk, or the like. In some embodiments, shapes of the upper cover 121 and the main body 122 may match each other. In some embodiments, the shape of the main body 122 may be a barrel shape, which includes a barrel bottom and a barrel sidewall. The barrel bottom may form the bottom wall of the crucible, and the barrel sidewall may form the sidewall of the crucible. In some embodiments, the shape of the main body 122 may be a cylindrical barrel body, and the shape of the upper cover 121 may be a circular disk. In some embodiments, the shape of the main body 122 may be a cuboid barrel body, and the shape of the upper cover 121 may be a rectangular disk or a square disk. In some embodiments, materials of the upper cover 121 and the main body 122 may be the same or may be different.

In some embodiments, a seed crystal 200 is arranged above the crucible 120, and a material 140 is arranged inside the crucible 120. In some embodiments, the seed crystal 200 may be bonded to the upper cover 121. The seed crystal 200 refers to a small crystal having the same crystal orientation as the crystals to be grown, which may serve as a seed for growing the crystals. In some embodiments, the seed crystal 200 may be obtained in a Physical Vapor Transport (PVT) manner, a Chemical Vapor Deposition (CVD) manner, a Czochralski manner, or the like. In some embodiments, the size of the seed crystal 200 may be 4 inches, 8 inches, or the like. In some embodiments, the type of the seed crystal 200 may be a 4H-Silicon Carbide (SiC) seed crystal, a 6H-Silicon Carbide (SiC) seed crystal, or the like.

The material 140 is a raw material configured to grow crystals. The raw material may include a material configured to supply a seed crystal for crystal growth. In some embodiments, a component of the raw material used to produce silicon carbide crystals may include SiC. In some embodiments, a component of the raw material for aluminum nitride crystals may include Aluminum Nitride (AlN). In some embodiments, the raw material may be in powder, granular, and/or bulk form.

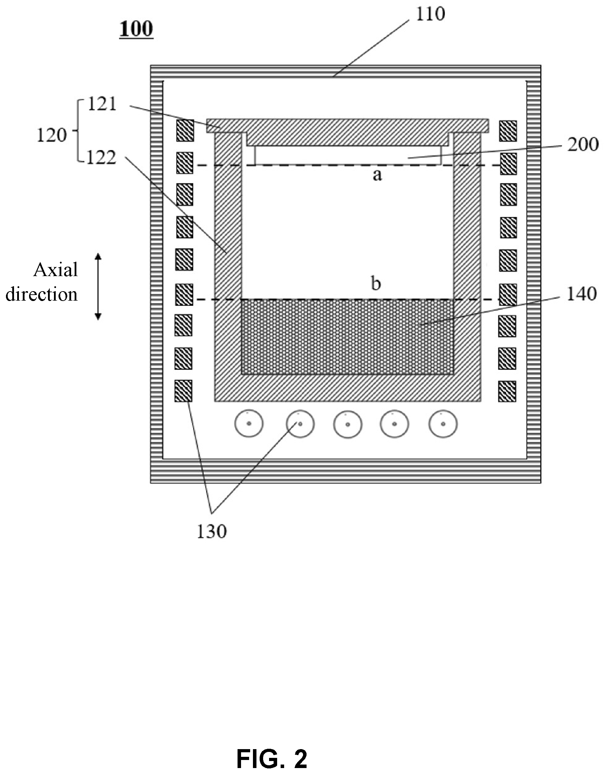

As shown in FIG. 2, the seed crystal 200 may be bonded to a lower side surface of the upper cover 121, and the material 140 may be placed in the main body 122. A dashed line 'a' in FIG. 2 represents a lower surface of the seed crystal 200, and a dashed line 'b' in FIG. 2 represents an upper surface of the material 140. A space between the dashed line 'a' and the dashed line 'b' is a space for crystal growth.

During a crystal growth stage, the material 140 in the crucible 120 is heated and sublimated into gaseous components. The gaseous components are transferred to the seed crystal 200 in a crystallization region, and then crystallize on a surface of the seed crystal 200 to generate crystals.

In some embodiments, the crucible 120 may further be provided with at least one temperature measuring assembly (not shown in FIG. 2). The temperature measuring assembly is configured to measure the temperature inside the crucible 120. Merely by way of example, the temperature measuring assembly may include a temperature sensor, an infrared thermometer, or the like.

In some embodiments, the at least one temperature measuring assembly may be configured to measure the temperature inside the crucible 120. For example, the at least one temperature measuring assembly may be configured to measure the temperature at at least one position, for example, at the lower surface of the seed crystal 200, at a crystal growth surface, at the upper surface of the material 140, at the space for crystal growth, or the like.

The heating assembly 130 is configured to heat the crucible 120 and provide a temperature field required for crystal growth. In some embodiments, when the heating assembly 130 heats the crucible 120, the temperature field may be formed inside the crucible 120 (i.e., in an inner cavity), thereby heating the material 140, allowing the material 140 to sublimate, so as to grow crystals on the growth surface of the seed crystal 200.

In some embodiments, the heating assembly 130 may include, but is not limited to, an electromagnetic induction heater, a resistance heater, or the like. In some embodiments, the electromagnetic induction heater may include an induction coil. The induction coil may generate eddy currents on an outer wall surface of the crucible 120 under the action of alternating current with different frequencies. Under the influence of eddy currents, electrical energy generated on the outer wall of crucible 120 may be converted into thermal energy. The thermal energy is conducted from the wall of the crucible 120 to the interior of the crucible 120, thereby forming the temperature field within the crucible 120. In some embodiments, the resistance heater may include one or more resistance wires. A material of the resistance wires may include, but is not limited to, at least one of graphite, tungsten, platinum, molybdenum, tantalum, or iridium. Correspondingly, the resistance heater may include, but is not limited to, at least one of a graphite resistance heater, a tungsten resistance heater, a platinum resistance heater, a molybdenum resistance heater, a tantalum resistance heater, or an iridium resistance heater.

In some embodiments, when the heating assembly 130 is an electromagnetic induction heater, the electromagnetic induction heater may be arranged around the crucible 120. In some embodiments, the electromagnetic induction heater may be arranged in an outer region of the crucible 120, at a certain distance from the outer wall of the crucible 120. In some embodiments, when the heating assembly 130 is a resistance heater, the resistance heater may be arranged on a crucible wall of the crucible 120 (e.g., the bottom wall or the sidewall). For example, the resistance heater may be embedded in the crucible wall of the crucible 120, or connected to an outer surface of the crucible wall of the crucible 120. In other embodiments, when the heating assembly 130 is a resistance heater, the resistance heater may be arranged at a certain distance from the crucible wall of the crucible 120 (e.g., the bottom wall or the sidewall).

Through heating of the crucible 120 by the heating assembly 130, one or more temperature gradients may be formed inside the crucible 120 (in the inner cavity). The one or more temperature gradients may include an axial temperature gradient and a radial temperature gradient. The axial temperature gradient refers to a temperature difference per unit distance along the axial direction of the inner cavity of the crucible 120. During crystal growth, in a direction from the bottom to the top of the inner cavity along the central axis of the inner cavity, a temperature decrease may form the axial temperature gradient. Such the axial temperature gradient may drive the gaseous components after sublimation of the material 140 to be transferred to the crystal growth surface. The radial temperature gradient refers to a temperature difference per unit distance on a horizontal cross-section at the same height of the inner cavity, in a direction from an inner wall of the crucible 120 to the central axis of the crucible 120. During crystal growth, since the heating assembly 130 generally heats the crucible 120 from outside the crucible 120, in a direction from the inner wall of the crucible 120 to the central axis of the crucible 120, the radial temperature gradient with decreasing temperature may be presented.

In some embodiments, the heating assembly 130 may be arranged at the bottom portion of the crucible 120 (hereinafter referred to as the bottom portion). In this case, the thermal energy is conducted from a bottom region inside the crucible 120 (an inner region close to the bottom portion) to a top region inside the crucible 120 (an inner region close to the top portion). At this time, the bottom region inside the crucible 120 may be a relatively high-temperature region, and the top region may be a relatively low-temperature region, thereby causing the axial temperature gradient inside the crucible 120 to monotonically decrease from bottom to top. In some embodiments, the heating assembly 130 may be arranged at the side of the crucible 120 (outside the crucible 120) (hereinafter referred to as the side). In this case, the thermal energy is conducted through the wall of the crucible 120, from an outer peripheral region inside the crucible 120 (a region close to the side of the crucible 120) to a central region inside the crucible 120 (a region close to the central axis of the crucible 120). At this time, the outer peripheral region inside the crucible 120 may be a relatively high-temperature region, and the central region may be a relatively low-temperature region, such that the temperature of the outer peripheral region of the crucible 120 is higher than the temperature of the central region of the crucible 120, thereby causing the radial temperature gradient to exist inside the crucible 120. In some embodiments, the heating assembly 130 may be arranged at the top portion of the crucible 120 (outside the crucible 120) (hereinafter referred to as the top). In this case, similar to the heating assembly 130 being arranged at the bottom portion of the crucible 120, the heating assembly 130 being arranged at the top portion of the crucible 120 causes the axial temperature gradient inside the crucible 120 to monotonically decrease from top to bottom. It should be noted that the descriptions of the axial temperature gradient and the radial temperature gradient inside the crucible 120 are for temperature gradient conditions when the heating assembly 130 is individually arranged only at corresponding positions (e.g., the heating assembly 130 is arranged only at the bottom portion of the crucible 120, only at the side of the crucible 120, or only at the top portion of the crucible 120). It may be understood that the heating assembly 130 may also be arranged at a plurality of positions (e.g., arranged at the side and the bottom of the crucible 120), which may cause a more complex temperature gradient inside the crucible 120. For example, when the heating assembly 130 is arranged at the bottom portion and the top portion of the crucible 120, the crucible 120 may have a situation where the temperatures at the top portion and the bottom portion are relatively high, while the temperature in an intermediate region between the top portion and the bottom portion is relatively low. It should be noted that the heating assembly 130 being arranged at the bottom portion of the crucible 120 may be understood to mean that at this time, the heating assembly 130 primarily heats the bottom portion of the crucible 120; the heating assembly 130 being arranged at the side of the crucible 120 may be understood to mean that at this time, the heating assembly 130 primarily heats the side of the crucible 120; and the heating assembly 130 being arranged at the top portion of the crucible 120 may be understood to mean that at this time, the heating assembly 130 primarily heats the top portion of the crucible 120.

In some embodiments, by adjusting the setting position of the heating assembly 130, the temperature distribution inside the crucible 120 may be adjusted to promote crystal growth in the crucible 120 and ensure crystal quality. In some embodiments, the heating assembly 130 may be arranged at the bottom portion and the side portion of the crucible 120. In some embodiments, the heating assembly 130 may be arranged at the bottom portion and the top portion of the crucible 120. In some embodiments, the heating assembly 130 may be arranged at the side portion and the top portion of the crucible 120. In some embodiments, the heating assembly 130 may be arranged at the bottom portion, the side portion, and the top portion of the crucible 120. Hereinafter, in conjunction with FIG. 2 to FIG. 13, a further description will be provided for an arrangement of the apparatus for crystal growth 100 and the heating assembly 130 thereof.

Hereinafter, a method for preparing a crystal by the apparatus for crystal growth 100 will be described by taking preparation of SiC single crystals as an example. The method may include the following steps.

In step 1, after placing the seed crystal 200 and the material 140 into the crucible 120, at least one of evacuating, performing leak detection, holding pressure, or cleaning the furnace is performed on the crucible.

Step 1 may be regarded as operations to be performed during a preparation stage of the crystal growth process.

In some embodiments, the seed crystal 200 may be bonded to the inner side surface of the upper cover 121, and the material 140 may be placed into the main body 122. The upper cover 121 having the seed crystal bonded thereto may then be covered on the top portion of the main body 122. The seed crystal 200 may be bonded to the inner side surface of the upper cover 121 by a bonding agent. The bonding agent may include, but is not limited to, epoxy resin adhesive, AB adhesive, phenolic resin adhesive, or sugar glue, or the like. Preferably, the bonding agent may be sucrose with 99.9% purity. During a process of bonding and fixing the seed crystal, uneven coating of the bonding agent, poor processing precision of the inner side surface of the upper cover 121, or the like, may lead to a generation of air bubbles or voids between a back surface of the seed crystal and the inner side surface of the upper cover 121, thereby causing the generated crystal to contain defects. Therefore, the formation of air bubbles or voids needs to be avoided when placing the seed crystal at the exact center of the inner side surface of the upper cover 121. In some embodiments, before bonding the seed crystal to the inner side surface of the upper cover, the seed crystal may also be cleaned to remove contaminants on the surface of the seed crystal. In some embodiments, the seed crystal may be cleaned with deionized water, an organic solvent, or the like.

In some embodiments, the material 140 (e.g., SiC powder or bulk material) may be placed into the main body 122, allowing the distance between the upper surface of the material 140 and the lower surface of the seed crystal 200 to be one of the following distances: 30 mm to 50 mm, 35 mm to 50 mm, 40 mm to 50 mm, 45 mm to 50 mm, 30 mm to 45 mm, 35 mm to 45 mm, 35 mm to 40 mm, 30 mm to 40 mm, 35 mm to 40 mm, 30 mm to 35 mm, or 40 mm to 45 mm, or the like. In some embodiments, the distance between the upper surface of the material 140 and the lower surface of the seed crystal 200 may be one of 30 mm, 35 mm, 40 mm, 45 mm, or 50 mm, or the like. In some embodiments, the surface of the material 140 placed in the main body 122 needs to remain flat.

After placing material 140 into the main body 122, the upper cover 121, having the seed crystal bonded thereto, may be placed on the top portion of the main body 122, thereby forming a sealed space and facilitating crystal growth.

In some embodiments, the loaded and covered crucible 120 may be placed into a temperature field for capping, evacuation, and leak detection, and then Step 2 is performed. For example, the evacuation processing may cause the pressure in the crucible 120 to reach 10-5 Pa. The time for the evacuation processing may be 3 hours to 5 hours. After the evacuation is completed, leak detection needs to be performed, and pressure needs to be held for 1 hour to 2 hours. When a leakage rate within 1 hour does not exceed 1 Pa, Step 2 may be started.

In step 2, the pressure in the inner cavity of the crucible 120 is adjusted by controlling the amount of gas introduced into the crucible 120, and the temperature in the inner cavity of the crucible 120 is adjusted by the heating assembly 130, for crystal growth.

In some embodiments, after the operations of the preparation stage (e.g., Step 1) are completed, a sealed space is formed in the crucible 120, and at this time, the operations of step 2 may be started. Step 2 may be regarded as operations to be performed during the crystal growth process. The crystal growth process may include a preheating stage, a crystal growth stage, and an annealing stage. The preheating stage is a stage in which heating and temperature increase are performed in the crucible 120 under high pressure, allowing the temperature in the crucible 120 to reach a temperature at which the material sublimates stably. In the preheating stage, the pressure in the crucible 120 is relatively high (e.g., maintained at 40 KPa to 80 KPa). The temperature in the crucible 120 increases (continuously increasing or periodically increasing). The crystal growth stage is the stage in which the material sublimates, thereby enabling continuous growth of the crystal on the seed crystal 200. In the crystal growth stage, the pressure in the crucible 120 may experience a significant reduction compared to the preheating stage (e.g., maintained at 1 KPa to 1.2 KPa), and the temperature in the crucible 120 may experience slight fluctuations (e.g., increases by 100°C to 300°C), but the temperature in the crucible 120 is generally maintained in a relatively stable temperature range (e.g., above 2000°C). More descriptions regarding the temperature of the crystal growth stage may be found in the following related descriptions. The annealing stage is a stage in which the crystal almost no longer grows, the pressure in the crucible 120 increases (e.g., increases again to 40 KPa to 80 KPa), but the temperature decreases (continuously decreasing or periodically decreasing). In the annealing stage, the heating assembly 130 may still heat the crucible 120, thereby controlling the cooling rate of the annealing stage (e.g., 1°C/min to 3°C/min). In some embodiments, changes in pressure and/or temperature within the crucible 120 may be used as nodes to distinguish the various stages. For example, when the pressure in crucible 120 starts to decrease rapidly from the high pressure of the preheating stage (e.g., a pressure drop rate greater than 20 kPa/h), the crystal growth stage begins. When the pressure in the crucible 120 starts to increase rapidly from the pressure of the crystal growth stage (e.g., a pressure rise rate greater than 20 KPa/h), combined with a decrease in temperature, the annealing stage starts.

In some embodiments, during the preheating stage, an inert gas (e.g., argon) may be introduced into the crucible 120, and the pressure may be maintained at 400 Pa to 800 Pa. In some embodiments, an inert gas (e.g., argon) may be introduced into the crucible 120, and the pressure may be controlled to be maintained in one of the following pressure ranges: 450 Pa to 800 Pa, 500 Pa to 800 Pa, 550 Pa to 800 Pa, 600 Pa to 800 Pa, 650 Pa to 800 Pa, 700 Pa to 800 Pa, 750 Pa to 800 Pa, 400 Pa to 750 Pa, 450 Pa to 750 Pa, 500 Pa to 750 Pa, 550 Pa to 750 Pa, 600 Pa to 750 Pa, 650 Pa to 750 Pa, 700 Pa to 750 Pa, 400 Pa to 700 Pa, 450 Pa to 700 Pa, 500 Pa to 700 Pa, 550 Pa to 700 Pa, 600 Pa to 700 Pa, 650 Pa to 700 Pa, 400 Pa to 650 Pa, 450 Pa to 650 Pa, 500 Pa to 650 Pa, 550 Pa to 650 Pa, 500 Pa to 650 Pa, 400 Pa to 600 Pa, 450 Pa to 600 Pa, 500 Pa to 600 Pa, 550 Pa to 600 Pa, 400 Pa to 550 Pa, 450 Pa to 550 Pa, 500 Pa to 550 Pa, 400 Pa to 500 Pa, 450 Pa to 500 Pa, or 400 Pa to 450 Pa, or the like. In some embodiments, an inert gas (e.g., argon) may be introduced into the crucible, and the pressure may be controlled to be maintained at one of the following pressure values: 450 Pa, 500 Pa, 550 Pa, 600 Pa, 650 Pa, 700 Pa, 750 Pa, or 800 Pa, or the like.

In some embodiments, during the crystal growth stage, the temperature of the crucible 120 may be maintained at 2100°C to 2400°C while the material 140 sublimates. In some embodiments, in the crystal growth stage, the temperature of the crucible 120 may be maintained at one of the following temperature ranges when the material 140 sublimates: 2150°C to 2400°C, 2200°C to 2400°C, 2250°C to 2400°C, 2300°C to 2400°C, 2350°C to 2400°C, 2100°C to 2350°C, 2150°C to 2350°C, 2200°C to 2350°C, 2250°C to 2350°C, 2300°C to 2350°C, 2100°C to 2300°C, 2150°C to 2300°C, 2200°C to 2300°C, 2250°C to 2300°C, 2100°C to 2250°C, 2150°C to 2250°C, 2200°C to 2250°C, 2100°C to 2200°C, 2150°C to 2200°C, or 2100°C to 2150°C, or the like. In some embodiments, during the crystal growth stage, the temperature of the crucible 120 may be maintained at one of the following temperatures when the material 140 sublimates: 2150°C, 2200°C, 2250°C, 2300°C, 2350°C, or 2400°C, or the like.

In some embodiments, during the preheating and crystal growth stages, the material 140 sublimates, and the total duration of the sublimation of the material 140 may be 40 to 60 hours. In some embodiments, the duration of the sublimation of the material 140 may be one of the following: 40 hours to 55 hours, 40 hours to 50 hours, 40 hours to 45 hours, 45 hours to 60 hours, 45 hours to 55 hours, 45 hours to 50 hours, 50 hours to 60 hours, 50 hours to 55 hours, or 55 hours to 60 hours, or the like. In some embodiments, a constant pressure time of a constant pressure cooling stage may also be one of the following: 40 hours, 42 hours, 44 hours, 46 hours, 48 hours, 50 hours, 52 hours, 54 hours, 56 hours, 58 hours, or 60 hours, or the like.

In some embodiments, after crystal growth is complete, the annealing stage begins. At this time, a protective gas (e.g., argon) may be introduced to adjust the pressure to 40 kPa to 80 kPa, and the temperature may be decreased at a rate of 1°C/min to 3°C/min.

The above preparation process is merely by way of example. Process parameters involved therein may be different in different embodiments, the sequence of the above steps is not unique, and the order between the steps may also be adjusted in different embodiments, or even one or a plurality of steps may be omitted. The above examples should not be construed as a limitation on the protection scope of the present disclosure.

In some embodiments, an apparatus for crystal growth may include a temperature control system. The temperature control system is configured to control temperature-related parameters of the heating assembly 130, thereby controlling the temperature and the temperature gradient in the crucible 120. In some embodiments, the temperature control system may ensure that the radial temperature gradient in the crucible during crystal growth does not exceed a preset radial temperature gradient threshold. In some embodiments, the temperature control system may ensure that the axial temperature gradient in the crucible during crystal growth does not exceed a preset axial temperature gradient threshold. In some embodiments, the preset radial temperature gradient threshold and/or the axial temperature gradient threshold may be pre-set. In some embodiments, the preset radial temperature gradient threshold and/or the axial temperature gradient threshold may be determined based on a preset condition. In some embodiments, the preset condition may include, but is not limited to, the size, shape, and material of the crucible, the size of the seed crystal, and the type and size of a crystal to be grown.

For growing a crystal using the PVT manner, the crystal growth stage may be implemented by controlling the temperature field distribution in the inner cavity of the crucible 120, thereby forming an axial temperature gradient between the material and the seed crystal in the crucible 120. The material, under high-temperature conditions, sublimes into a gas-phase component, which is transported to the seed crystal by the axial temperature gradient. Since the temperature at the location of the seed crystal is relatively low, the gas-phase component may form a crystal on the surface of the seed crystal. In some embodiments, the crystal may include, but is not limited to, a SiC crystal, an AlN crystal, a zinc oxide crystal, or a zinc antimonide crystal.

In some embodiments, the heating assembly 130 may include a first heating assembly 131, which is primarily configured to heat the bottom portion of the crucible 120. The first heating assembly 131 may be disposed near the bottom portion of the crucible 120. If only the first heating assembly 131 is provided, the axial temperature gradient in the crucible 120 may be difficult to control. If a main heating portion of the heating assembly 130 is at the bottom portion of the crucible 120, when a heating temperature of the first heating assembly 131 is relatively high, it may cause the axial temperature gradient in the crucible 120 to be excessively large, thereby causing crystal growth defects and reducing the quality and yield of the crystal. Specifically, since the axial temperature gradient in the inner cavity is excessively large, causing mass transfer to be too fast, resulting in an excessively fast deposition rate of the gas-phase component on the lower surface of the seed crystal, leading to a relatively large stress being formed on a crystal growth surface, which may easily form defects such as inclusions, or the like, thereby causing other dislocation defects and affecting the crystal quality. When the heating temperature of the first heating assembly 131 is relatively low, it may further cause an overall temperature in the crucible 120 to be excessively low or the axial temperature gradient to be excessively small, which may further cause insufficient driving force, leading to an excessively slow deposition rate of the gas-phase component on the lower surface of the seed crystal, and thus failing to meet requirements of the PVT manner for mass transfer. If the axial temperature gradient is unstable, the gas-phase component is unevenly distributed along the axial direction, which may lead to poor crystal quality.

In some embodiments, the heating assembly 130 may include a second heating assembly 132, which is primarily configured to heat the side portion of the crucible 120. The second heating assembly 132 may be disposed near the side of the crucible 120 or around the side of the crucible 120. If only the second heating assembly 132 is provided, the axial temperature gradient and the radial temperature gradient in the crucible 120 may both be difficult to control. If a main heating portion of the heating assembly 130 is at the side portion of the crucible 120, when the heating temperature of the first heating assembly 131 is relatively high, it may cause temperatures of the gas-phase component after material sublimation to have significant differences in the radial direction of the crucible 120, a relatively large radial temperature gradient may cause crystal growth defects and reduce the quality and yield of the crystal. In addition, since the radial temperature gradient of the crucible 120 is relatively large, causing a concentration of the gas-phase component after material sublimation to be unevenly distributed along the radial direction, at this time, a gas-phase transport path is transmitted diagonally from an edge to a center. This transport manner may cause differences in the gas-phase concentration at a crystal growth interface, thereby leading to defects such as non-planar crystal growth, high internal stress in the crystal, and extreme ease of generating dislocations and cracking, or the like, which directly limits the improvement of the crystal quality. When the heating temperature of the first heating assembly 131 is relatively low, it may further cause the axial temperature gradient in the crucible 120 to be excessively small, which may further cause insufficient driving force, leading to the excessively slow deposition rate of the gas-phase component on the lower surface of the seed crystal, and thus failing to meet requirements of the PVT manner for mass transfer.

According to an aspect of the present disclosure, an apparatus for crystal growth is provided. Through a specific configuration of the heating assembly 130, the temperature distribution or the temperature gradient in the crucible 120 is affected, allowing the temperature gradient in the crucible 120 to meet requirements of temperature-related parameters, such as the radial temperature gradient and the axial temperature gradient, or the like, for crystal growth by the PVT, thereby ensuring the crystal growth quality.

FIG. 2 is a schematic diagram illustrating an apparatus for crystal growth according to some embodiments of the present disclosure. As shown in FIG. 2, the heating assembly 130 includes the first heating assembly 131 and the second heating assembly 132. The first heating assembly 131 is configured to heat the bottom portion of the crucible 120, and the second heating assembly 132 is configured to heat the side portion of the crucible 120. The first heating assembly 131 being configured to heat the bottom portion of the crucible 120 may be understood as that the first heating assembly 131 is mainly configured to heat the bottom portion of the crucible 120, which means heat provided by the first heating assembly 131 to the bottom portion is higher than heat provided by the first heating assembly 131 to other portions of the crucible (e.g., the side, the top). In addition, the bottom portion of the crucible 120 may include the bottom wall of the crucible 120 and a region of the sidewall of the crucible 120 near the bottom wall. For example, by dividing the sidewall of the crucible 120 into three regions, namely an upper portion, a middle portion, and a lower portion, along an axial length of the crucible 120, the region of the sidewall of the crucible 120 near the bottom wall may be the lower portion of the sidewall. The second heating assembly 132 being configured to heat the side of the crucible 120 may be understood as that the second heating assembly 132 is mainly configured to heat the side portion of the crucible 120, which means heat provided by the second heating assembly 132 to the side portion is higher than heat provided by the second heating assembly 132 to other portions of the crucible (e.g., the bottom, the top). The side portion of the crucible 120 may refer to the sidewall of the crucible 120.

In the present embodiment, the heating assembly 130 includes both the first heating assembly 131 and the second heating assembly 132, which allows both the bottom portion and the side portion of the crucible 120 to be heated in a targeted manner, and allows bottom heating and side heating of the crucible 120 to be controlled separately, respectively, thereby facilitating the control of the temperature gradient in the crucible 120 (including the axial temperature gradient and the radial temperature gradient). By independently adjusting parameters such as the heating power and heating time of the first heating assembly 131 and the second heating assembly 132, the bottom temperature and the side temperature may be adjusted more flexibly to control and adjust the temperature distribution in the crucible 120. Specifically, since the first heating assembly 131 is mainly configured to heat the bottom portion of the crucible 120, it may provide a relatively large axial temperature gradient, and a heating region of the second heating assembly 132 may cover a relatively long range of the crucible 120 in the axial direction, which is beneficial for ensuring the overall temperature in the crucible 120, so that the heating temperature of the first heating assembly 131 may not need to be set too high, thereby avoiding a situation where the axial temperature gradient in the inner cavity is excessively large. And due to the presence of the first heating assembly 131, the heating temperature of the second heating assembly 132 may not need to be set too high, thereby avoiding an excessively large radial temperature gradient in the inner cavity.

In some embodiments, the first heating assembly 131 includes a first resistance heater 1311, and heating is implemented through resistance heating. In some embodiments, the first resistance heater 1311 may be arranged to extend along a plane parallel to the bottom wall of the crucible 120 (a wall body near the bottom of the crucible), and is spaced apart from the bottom wall of the crucible 120. In some embodiments, the projection coverage area of the first resistance heater 1311 along the axial direction of the crucible 120 may be greater than or equal to the projection coverage area of the inner cavity of the crucible 120 along the axial direction, allowing a heat radiation range of the first resistance heater 1311 to cover the bottom portion of the crucible 120, thereby uniformly heating the material. The projection coverage area refers to an area of a region covered by a projection. In some embodiments, to avoid arcing in resistance heating, the axial distance between the first resistance heater 1311 and the bottom wall of the crucible 120 may be greater than 20 mm (e.g., 25 mm or 30 mm).

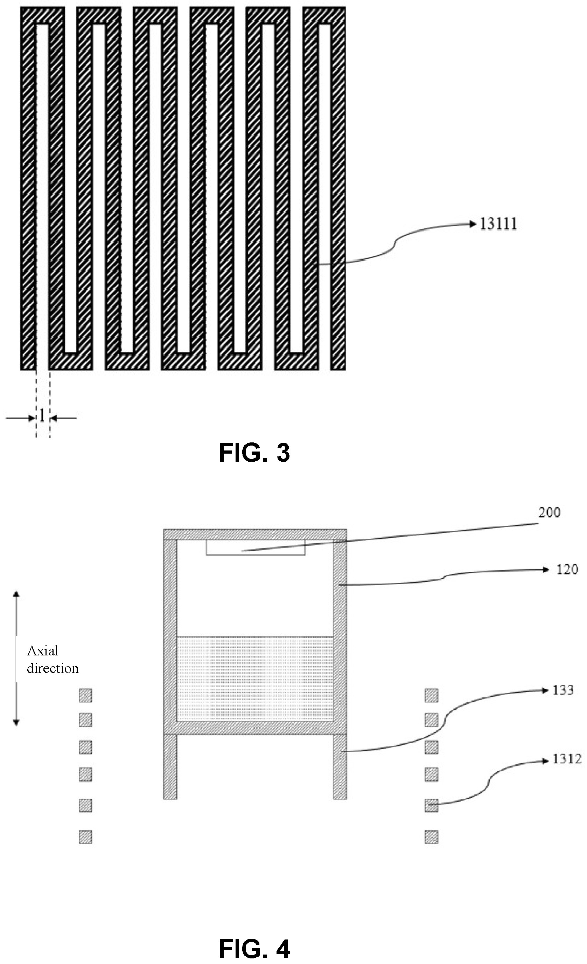

FIG. 3 is a schematic diagram illustrating a resistance heater according to some embodiments of the present disclosure. In some embodiments, as shown in FIG. 3, the first resistance heater 1311 includes resistance wires 13111, and the resistance wires 13111 may be disposed in one or more distribution manners, such as a serpentine distribution, a winding distribution, a row distribution, a column distribution, or the like. In some embodiments, to avoid arcing in resistance heating, a minimum spacing l between resistance wires 13111 is in the range of 10 mm to 15 mm (e.g., 11 mm to 14 mm or 12 mm to 13 mm). It should be noted that the minimum spacing l between the resistance wires 13111 may be understood as the minimum interval distance between the spaced-apart resistance wires 13111 at various positions and angles. Taking the resistance wires 13111 in a row distribution as an example, the minimum interval distance may be a row spacing.

In some embodiments, the first resistance heater 1311 may be embedded inside the bottom wall of the crucible 120. For example, a groove is formed on the bottom wall of the crucible 120, and the first resistance heater 1311 is correspondingly installed in the groove, at this time, a gap may exist between the first resistance heater 1311 and the bottom wall of the crucible 120, to avoid arcing. The first resistance heater 1311 directly implements heat transfer to the interior of the crucible 120 through the bottom wall of the crucible 120, thereby improving heat transfer efficiency.

FIG. 4 is a schematic diagram illustrating an arrangement of the first induction coil according to some embodiments of the present disclosure. In some embodiments, as shown in FIG. 4, the first heating assembly 131 includes a first induction coil 1312, and the first induction coil 1312 is configured to heat the bottom portion of the crucible 120 through electromagnetic induction. The first induction coil 1312 is sleeved on the outside of the crucible 120 and is arranged around the bottom wall of the crucible 120. In some embodiments, the bottom end of the first induction coil 1312 in the axial direction is lower than the bottom portion of the crucible 120 in the axial direction. In some embodiments, the central axis of the first induction coil 1312 coincides with the central axis of the crucible 120, thereby allowing the crucible 120 to be evenly heated. In some embodiments, the midpoint of the axial length of the first induction coil 1312 may be located at the plane of the bottom wall of the crucible 120, or below the plane of the bottom wall of the crucible 120.

In some embodiments, to improve the heating effect of the first induction coil 1312 on the bottom portion of the crucible 120, a graphite ring 133 is arranged at the bottom portion of the crucible 120. The graphite ring 133 is an annular structure, and the shape of a cross-section of the graphite ring 133 perpendicular to an axis of the crucible 120 may match the shape of the main body 122 of the crucible 120. For example, when the main body 122 is a cylindrical barrel, the graphite ring 133 is a ring structure. In some embodiments, the central axis of the graphite ring 133 may coincide with the central axis of the crucible 120. In some embodiments, a side of the graphite ring 133 close to the crucible 120 may be connected to the bottom wall of the crucible 120. In some embodiments, the outer diameter of the graphite ring 133 may be smaller than the diameter of the bottom of the crucible. In some embodiments, to ensure the high heat generation efficiency and the heat transfer efficiency, the outer diameter of the graphite ring 133 is equal to the diameter of the bottom portion of the crucible 120. In some embodiments, in the axial direction, a height dimension of the graphite ring 133 is 1/4 to 1/2 (e.g., 1/3) of a height dimension of the crucible 120. During a crystal growth process, a thermal energy concentrated region of the first induction coil 1312 is adjusted onto the graphite ring 133. The graphite ring 133 transfers the thermal energy to the bottom portion of the crucible 120. At this time, the heat supplied to the bottom portion of the crucible 120 includes the heat transferred by the graphite ring 133 and the heat from the induction heating of the first induction coil 1312, thereby achieving better heating of the bottom portion of the crucible 120 by electromagnetic induction.

In some embodiments, referring to FIG. 2, to better heat the side portion of the crucible 120, the second heating assembly 132 includes the second induction coil 1321. The second induction coil 1321 is arranged around the sidewall of the crucible 120, thereby achieving relatively even heating of the side of the crucible 120 by electromagnetic induction. In some embodiments, the bottom end of the second induction coil 1321 in the axial direction is lower than the bottom wall of the crucible 120, or the bottom end of the second induction coil 1321 in the axial direction is located at a plane of the bottom wall of the crucible 120. In some embodiments, the top end of the second induction coil 1321 in the axial direction is higher than the top end of the crucible 120 (e.g., the upper cover of the crucible 120), or the top end of the second induction coil 1321 in the axial direction is flush with the top end of the crucible 120 (e.g., the top end of the second induction coil 1321 in the axial direction is located at a plane where the upper cover of the crucible 120 is located). By arranging positions of the top end and the bottom end of the second induction coil 1321 relative to the top end of the crucible 120 and the bottom end of the crucible 120, thermal energy of the second induction coil 1321 can cover an entire side of the crucible 120. In some embodiments, a central axis of the second induction coil 1321 coincides with the central axis of the crucible 120, thereby allowing the entire side of the crucible 120 to receive even heat.

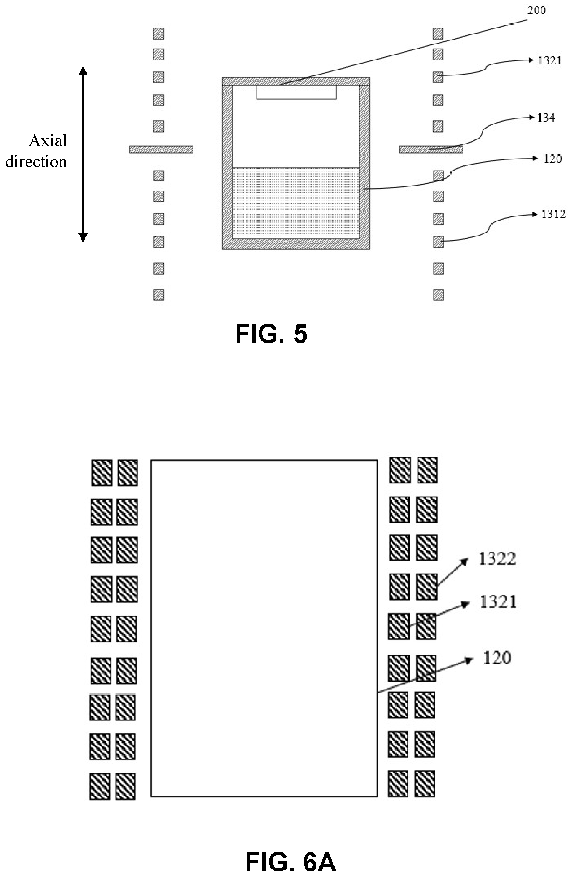

FIG. 2 shows an embodiment where the first heating assembly 131 includes the first resistance heater 1311, and the second heating assembly 132 includes the second induction coil 1321. By heating the bottom portion of the crucible 120 by the first resistance heater 1311, heating efficiency can be improved, and a more ideal axial temperature gradient can be formed in the inner cavity. An embodiment where the first heating assembly 131 includes the first induction coil 1312 and the second heating assembly 132 includes the second induction coil 1321 is shown in FIG. 5.

FIG. 5 is a schematic diagram illustrating arrangements of the first induction coil and the second induction coil according to some embodiments of the present disclosure. In some embodiments, as shown in FIG. 5, both the first induction coil 1312 and the second induction coil 1321 are arranged around the side of the crucible 120, and the first induction coil 1312 is located below the second induction coil 1321 in the axial direction of the crucible 120. The first induction coil 1312 heats the bottom portion and a lower part of the side portion of the crucible 120, and the second induction coil 1321 heats an upper part of the side of the crucible 120. By arranging a plurality of induction coils to perform partitioned heating of the side portion of the crucible 120, the temperature difference between the crystal surface and the material 140 may be well controlled, thereby achieving a better temperature gradient within the crucible 120. In some embodiments, the power of the first induction coil 1312 may be greater than the power of the second induction coil 1321.

In some embodiments, the bottom end of the second induction coil 1321 in the axial direction is spaced apart from the top end of the first induction coil 1312 in the axial direction, to avoid mutual interference between the first induction coil 1312 and the second induction coil 1321. The top end of the second induction coil 1321 in the axial direction is located on the same horizontal line (perpendicular to the axial direction) as the top of the crucible 120 in the axial direction, or the top end of the second induction coil 1321 in the axial direction is higher than the top of the crucible 120 in the axial direction. The bottom end of the first induction coil 1312 in the axial direction is lower than the bottom of the crucible 120 in the axial direction, or the bottom end of the first induction coil 1312 in the axial direction is located on the same horizontal line (perpendicular to the axial direction) as the bottom of the crucible 120 in the axial direction. In some embodiments, the central axis of the first induction coil 1312 and the central axis of the second induction coil 1321 both coincide with the central axis of the crucible 120. More descriptions regarding the first induction coil 1312 shown in FIG. 5 may be found elsewhere in the present disclosure (e.g., FIG. 3 and related descriptions thereof).

In some embodiments, an annular baffle 134 is arranged between the bottom end of the second induction coil 1321 in the axial direction and the top end of the first induction coil 1312 in the axial direction, and the annular baffle 134 is configured to block electromagnetic interference between the induction coils. In some embodiments, the annular baffle 134 is an annular structure arranged around the crucible 120. In some embodiments, a material of the annular baffle 134 is a material that can shield electromagnetic interference (e.g., aluminum, copper, iron, nickel, silver, or the like).

In some embodiments, during the crystal growth stage, to provide the axial temperature gradient, the first heating assembly 131 providing bottom heating may be primary, and the second heating assembly 132 providing side heating may be auxiliary. That is, the heat provided by the first heating assembly 131 to the crucible 120 exceeds the heat provided by the second heating assembly 132. In some embodiments, during the crystal growth stage, the ratio of the bottom heat to the side heat obtained by the material in the crucible 120 is 1 to 4 (i.e., 1:1 to 4:1). In some embodiments, during the crystal growth stage, the ratio of bottom heat to side heat is 1 to 4 (i.e., 1:1 to 4:1). The bottom heat refers to the heat provided by the first heating assembly 131 and received by the crucible 120; and the side heat refers to the heat provided by the second heating assembly 132 and received by the crucible 120. In some embodiments, an effective power ratio of the first heating assembly 131 to the second heating assembly 132 may be 3:2 to 4:1 (e.g., 3:1 or 2:1). In some embodiments, during the annealing stage, to minimize the radial temperature gradient inside a crystal, only the first heating assembly 131 may perform heating. More descriptions regarding the crystal growth stage may be found in the preceding related descriptions.

It should be noted that structures and arrangements of the first heating assembly 131 and the second heating assembly 132 shown in FIGs. 2 to 5 are merely schematic and are not intended to be limiting. Those skilled in the art may make modifications or adjustments to the embodiments without inventive effort. For example, the first heating assembly 131 may simultaneously include the first resistance heater 1311 (at this time, an electromagnetic shielding shell may be wrapped around the outside of the first resistance heater 1311) and the first induction coil 1312. The first resistance heater 1311 may be arranged inside the graphite ring 133, and the graphite ring 133 spaces apart the first induction coil 1312 and the first resistance heater 1311. These modifications or adjustments are still within the scope of the present disclosure.

In some embodiments, the second heating assembly 132 arranged at the side portion of the crucible 120 may heat the side portion of the crucible 120 by arranging the plurality of induction coils. FIG. 6A is a schematic diagram illustrating an exemplary second heating assembly according to some embodiments of the present disclosure. In some embodiments, as shown in FIG. 6A, the second heating assembly 132 includes the second induction coil 1321 and a third induction coil 1322, and the third induction coil 1322 is sleeved on the outside of the second induction coil 1321. A structure of the third induction coil 1322 may be similar to the structure of the second induction coil 1321. In some embodiments, axial lengths of the second induction coil 1321 and the third induction coil 1322 are greater than a height of the inner cavity of the crucible 120 along the axial direction of the crucible 120. By using both the second induction coil 1321 and the third induction coil 1322, the second heating assembly 132 may be more flexible in controlling the temperature within the crucible 120, and the maximum heat obtainable within the crucible 120 can also be increased.

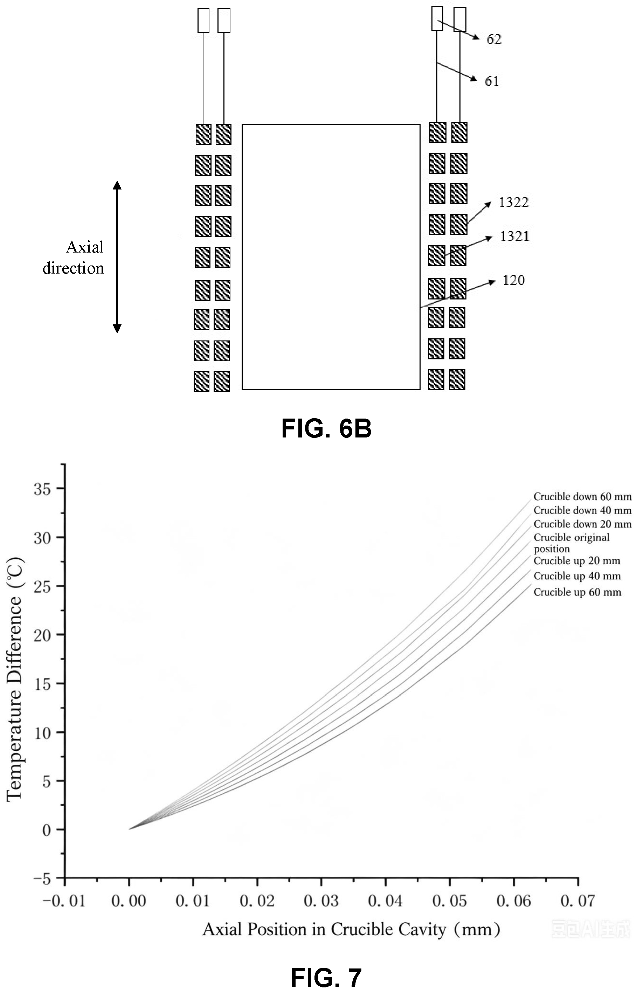

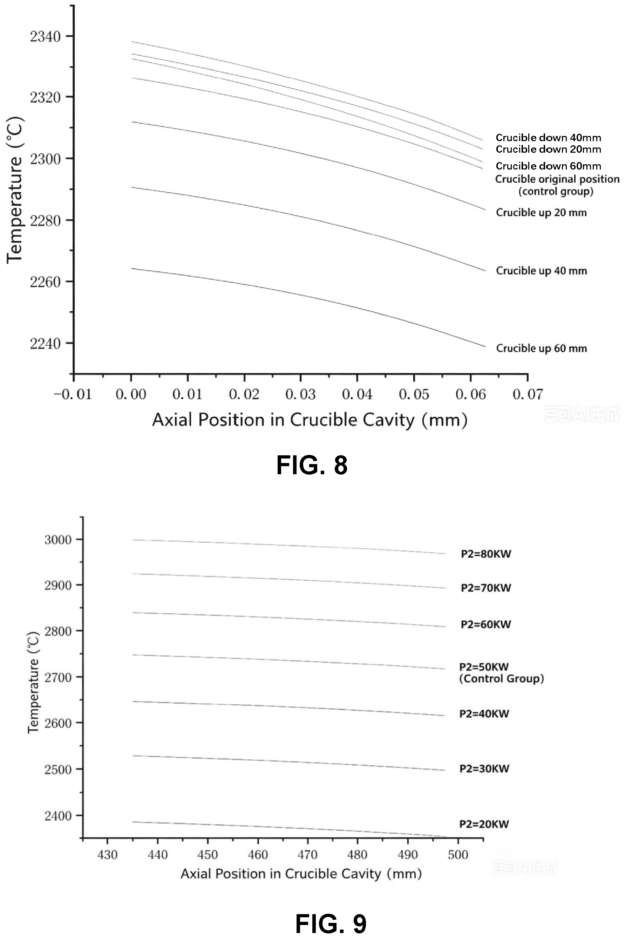

In some embodiments, the apparatus for crystal growth 100 includes a first induction coil moving mechanism 60 and a second induction coil moving mechanism. The first induction coil moving mechanism 60 is configured to drive the second induction coil 1321 to move along the axial direction of the crucible 120, and the first induction coil moving mechanism 60 is connected to the second induction coil 1321. The second induction coil moving mechanism is configured to drive the third induction coil 1322 to move along the axial direction of the crucible 120, and the second induction coil driving mechanism is connected to the third induction coil 1322. In some embodiments of the present disclosure, the first induction coil moving mechanism drives the second induction coil, which is located at a side portion of the crucible 120, to move along the axial direction of the crucible 120. This may allow for adjustment of the relative position between the crucible 120 and the second heating assembly 132, thereby adjusting the position where the side portion of the crucible 120 may obtain the most heat, and thereby adjusting the temperature distribution inside the crucible 120 (e.g., adjusting the position of a high temperature line within the crucible 120). When the second induction coil 1321 and the third induction coil 1322 are driven to move in the same direction along the axial direction of the crucible 120, this is equivalent to the relative position between the second induction coil 1321 and the third induction coil 1322 remaining unchanged. Upon adjustment of the position of the crucible 120, the temperature distribution inside the crucible 120 may also change. More descriptions regarding this may be found elsewhere in the present disclosure (e.g., FIG. 7 and FIG. 8 and related descriptions thereof). In some embodiments of the present disclosure, when the second induction coil 1321 and the third induction coil 1322 are driven to move in opposite directions along the axial direction of the crucible 120, the heating temperature at the overlapping position of the second induction coil 1321 and the third induction coil 1322 is the highest. The temperature distribution inside the crucible 120 may be adjusted by adjusting the position of the overlapping position of the second induction coil 1321 and the third induction coil 1322 relative to the crucible 120 (e.g., adjusting the position of a high temperature line within the crucible 120).

FIG. 6B is a schematic diagram illustrating the second heating assembly and the first induction coil moving mechanism according to some embodiments of the present disclosure. In some embodiments of the present disclosure, as shown in FIG. 6B, the first induction coil moving mechanism 60 may include one or a plurality of lifting rods 61 and a driving component 62. An upper end of each of the lifting rods 61 is connected to the driving component 62, and a lower end of each of the lifting rods 61 is connected to the second induction coil 1321. The driving component 62 may drive the second induction coil 1321 to move along the axial direction of the crucible 120 through the lifting rods 61. The driving component 62 may include a motor, a hydraulic cylinder, a pneumatic cylinder, or the like. It may be understood that the lifting rods 61 may also be replaced by a combination of a lifting rope and a rope wheel, wherein the lifting rope is wound around the rope wheel. At this time, the driving component 62 may drive the rope wheel to rotate, thereby causing the lifting rope to lift or lower the second induction coil 1321, to adjust the axial position of the second induction coil 1321 relative to the crucible 120. In other embodiments of the present disclosure, the first induction coil moving mechanism 60 may include a lifting mechanism arranged below the second induction coil 1321. For example, the lifting mechanism may include a telescopic rod and the driving component 62 configured to extend and retract the telescopic rod. The driving component 62 drives the telescopic rod to extend and retract. The telescopic rod may extend to lift the second induction coil 1321 or retract to lower the second induction coil 1321, to adjust the axial position of the second induction coil 1321 relative to the crucible 120. The structure of the second induction coil moving mechanism may be similar to the structure of the first induction coil moving mechanism. More descriptions regarding the first induction coil moving mechanism may be found in the related descriptions.

In some embodiments of the present disclosure, the relative position between the crucible 120 and the second heating assembly may also be adjusted by moving the crucible 120 along the axial direction of the crucible 120. Merely by way of example, the crucible 120 may be arranged on a lifting platform.

FIG. 7 is a diagram illustrating an axial temperature gradient in the inner cavity of the crucible at different positions. FIG. 8 is a diagram illustrating the axial temperature distribution in the inner cavity of the crucible at different positions. While ensuring that the structure, position, and power input of the second induction coil 1321 and the third induction coil 1322 remain unchanged, starting from an original position of the crucible 120, the crucible 120 is moved upward along the axial direction at equal intervals by 20 mm, 40 mm, and 60 mm, and moved downward along the axial direction at equal intervals by 20 mm, 40 mm, and 60 mm, to simulate the temperature influence of the change in the crucible's position on the inner cavity of the crucible. That is to say, the variable is only the position of the crucible 120 relative to the second induction coil 1321 and the third induction coil 1322. The top ends and the bottom ends of the second induction coil 1321 and the third induction coil 1322 are aligned. When the crucible 120 is at the original position, the bottom ends of the second induction coil 1321 and the third induction coil 1322 are located below the bottom wall of the crucible 120, and the distance between the bottom wall of the crucible 120 and the bottom ends of the second induction coil 1321 and the third induction coil 1322 is 50 mm to 150 mm; the top ends of the second induction coil 1321 and the third induction coil 1322 are located above the upper cover of the crucible 120, and the distance between the upper cover 121 of the crucible 120 and the top ends of the second induction coil 1321 and the third induction coil 1322 is 50 mm to 100 mm. In FIG. 7, the x-axis represents the axial position within the inner cavity of the crucible 120 (the x-axes of FIG. 8, FIG. 9, and FIG. 11B are similar to the x-axis of FIG. 7), and the y-axis represents the temperature difference (i.e., °C) within the inner cavity of the crucible 120. The curves in FIG. 7 may illustrate the temperature change values at different axial positions of the crucible 120 (relative to the reference position, where the x-axis is 0 mm). For example, the point where the x-axis is 0 mm corresponds to the upper surface of the bottom wall of the crucible 120 (the x-axes in FIG. 8, FIG. 9, and FIG. 11B are similar to the x-axis in FIG. 7), and the temperature difference at this time is 0 °C. The position where the x-axis is 0.01 mm corresponds to a position 0.01 mm above the upper surface of the bottom wall. For the curve where the crucible 120 is moved downward by 60 mm, the temperature difference between the position 0.01 mm above the upper surface of the bottom wall of the crucible 120 and the upper surface of the bottom wall of the crucible 120 is approximately 4 °C. Therefore, the curves in FIG. 7 may represent the temperature gradient within the inner cavity of the crucible 120. It can be seen from FIG. 7 that after the crucible 120 is moved upward by 60 mm from the original position, its overall axial temperature gradient is the smallest. The axial temperature gradient within the inner cavity of the crucible 120 decreases with increasing height to which the crucible 120 is raised relative to the induction coils (e.g., the second induction coil 1321 and the third induction coil 1322). The result of moving the crucible 120 downward by 60 mm from the original position is opposite to the result of moving the crucible 120 upward. Overall, as the position of the crucible 120 relative to the induction coils (e.g., the second induction coil 1321 and the third induction coil 1322) moves from bottom to top, the temperature gradient within the inner cavity of the crucible 120 gradually decreases. In FIG. 8, the x-axis represents the axial position within the inner cavity of the crucible 120, and the y-axis represents the temperature (°C) within the inner cavity of the crucible 120. It can be seen from FIG. 8 that, compared to moving the crucible 120 downward, moving the crucible 120 upward brings a greater influence on the temperature inside the crucible 120. During moving the crucible 120 upward, as the height by which the crucible 120 moves upward gradually increases, the overall temperature within the inner cavity of the crucible 120 decreases; during moving the crucible downward at equal intervals, the overall temperature change is smaller, the temperature field change is complex, and there is no obvious pattern. Based on FIG. 7 and FIG. 8, it can be seen that the relative position between the crucible 120 and the induction coils may affect the overall temperature and the temperature gradient within the crucible 120. By adjusting the axial position of the second induction coil 1321 and the third induction coil 1322 relative to the crucible 120, the overall temperature and the temperature gradient inside the crucible 120 may be adjusted.

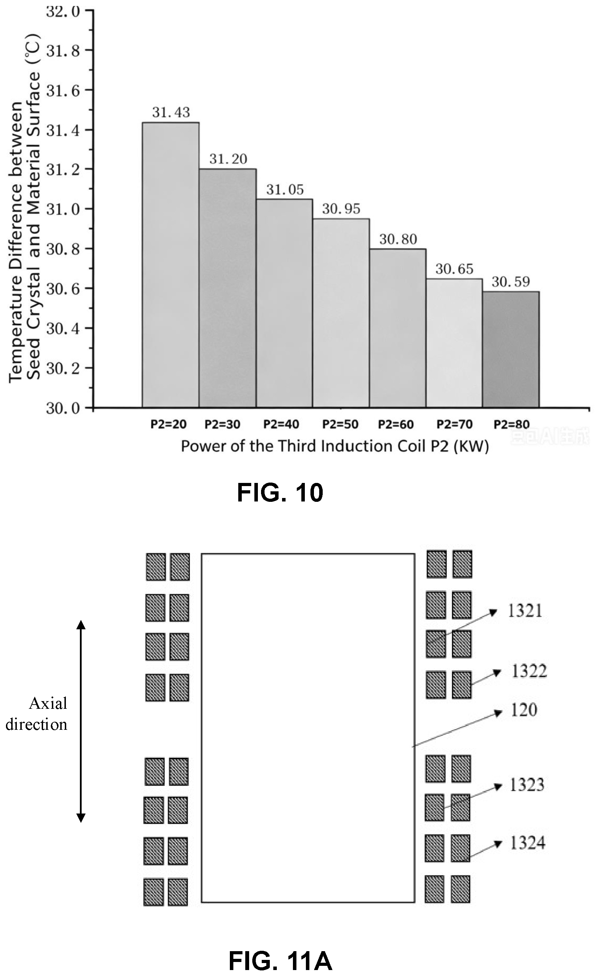

In some embodiments of the present disclosure, the temperature distribution inside the crucible 120 may be adjusted by adjusting the power of the second induction coil 1321 and the third induction coil 1322. More descriptions regarding this may be found elsewhere in the present disclosure (e.g., FIG. 9 and FIG. 10 and related descriptions thereof). FIG. 9 is a diagram illustrating the axial temperature distribution in the inner cavity of the crucible for the third induction coil at different powers. In FIG. 9, the x-axis represents the axial position within the inner cavity of the crucible 120, and the y-axis represents the temperature (°C) within the inner cavity of the crucible 120. FIG. 10 is a bar chart illustrating the temperature difference between the seed crystal and the material surface corresponding to the third induction coil at different powers. In FIG. 10, the x-axis represents the power of the third induction coil 1322, and the y-axis represents the temperature difference (°C) between the seed crystal and the material surface (the upper surface of the material within the crucible 120). The power P1 of the second induction coil is set to 50 kW, and the power P2 of the third induction coil is set to be 20 kW, 30 kW, 40 kW, 50 kW, 60 kW, 70 kW, and 80 kW, respectively. The experimental group in which the power P2 of the third induction coil is equal to the power P1 of the second induction coil (P1=P2=50 kW) is a control group. It can be seen from FIG. 9 that as the power of the third induction coil increases, the temperature within the inner cavity of the crucible gradually increases. It can be seen from FIG. 10 that the temperature difference between the seed crystal and the material surface is the smallest when the power of the third induction coil is 80 kW, and the temperature difference between the seed crystal and the material surface is the largest when the power is 20 kW. As the power of the third induction coil increases, the temperature difference between the seed crystal and the material surface also gradually decreases. Based on FIG. 9 and FIG. 10, it can be seen that the power of the induction coils (e.g., the second induction coil 1321 and the third induction coil 1322) may affect the overall temperature and the temperature gradient within the crucible 120. By adjusting the power of the second induction coil 1321 and the third induction coil 1322, the overall temperature and the temperature gradient inside the crucible 120 may be adjusted.

In some embodiments of the present disclosure, the apparatus for crystal growth further comprises a fourth induction coil 1323, arranged below the second induction coil 1321 in the axial direction of the crucible 120. The fourth induction coil 1323 may be spaced apart from the second induction coil 1321 along the axial direction of the crucible 120. In some embodiments of the present disclosure, the fourth induction coil 1323 may be mainly configured to heat the material contained within the crucible 120. In some embodiments of the present disclosure, the second induction coil 1321 may be mainly configured to heat the region between the upper surface of the material within the crucible 120 and a crystal growth cross-section. By spacing the induction coils (e.g., the second induction coil 1321 and the fourth induction coil 1323) apart along the axis of the crucible 120, different regions of the crucible 120 may be temperature-controlled more flexibly, thereby controlling the axial temperature gradient within the crucible 120.

FIG. 11A is a schematic diagram illustrating another exemplary second heating assembly according to some embodiments of the present disclosure. In some embodiments of the present disclosure, as shown in FIG. 11A, the second heating assembly 132 includes the second induction coil 1321, the third induction coil 1322, the fourth induction coil 1323, and a fifth induction coil 1324. The second induction coil 1321 and the fourth induction coil 1323 are both arranged around the side portion of the crucible 120. The third induction coil 1322 is sleeved on the outside of the second induction coil 1321, and the fifth induction coil 1324 is sleeved on the outside of the fourth induction coil 1323. The fourth induction coil 1323 is arranged below the second induction coil 1321 in the axial direction of the crucible 120, and the fifth induction coil 1324 is arranged below the third induction coil 1322 in the axial direction of the crucible 120. In some embodiments of the present disclosure, the bottom end in the axial direction of the second induction coil 1321 is spaced apart from the top end in the axial direction of the fourth induction coil 1323, and the bottom end in the axial direction of the third induction coil 1322 is spaced apart from the top end in the axial direction of the fifth induction coil 1324. In some embodiments, the top end of the second induction coil 1321 in the axial direction is higher than the top portion of the crucible 120 in the axial direction, the bottom end of the fourth induction coil 1323 in the axial direction is lower than the bottom portion of the crucible 120 in the axial direction, and the top end of the third induction coil 1322 in the axial direction is higher than the top portion of the crucible 120 in the axial direction, and the bottom end of the fifth induction coil 1324 in the axial direction is lower than the bottom portion of the crucible 120 in the axial direction. In some embodiments, the central axes of the second induction coil 1321, the third induction coil 1322, the fourth induction coil 1323, and the fifth induction coil 1324 all coincide with the central axis of the crucible 120. In some embodiments, by adjusting the positions of the second induction coil 1321, the third induction coil 1322, the fourth induction coil 1323, and the fifth induction coil 1324 relative to the crucible 120 in the axial direction, and/or, by respectively adjusting the power of the second induction coil 1321, the third induction coil 1322, the fourth induction coil 1323, and the fifth induction coil 1324, the temperature distribution inside the crucible 120 can be adjusted.

Through the arrangement of the four induction coils (the second induction coil 1321, the third induction coil 1322, the fourth induction coil 1323, and the fifth induction coil 1324), the second induction coil 1321 and the third induction coil 1322, which are located at an upper portion, and the fourth induction coil 1323 and the fifth induction coil 1324, which are located at a lower portion, respectively heat different regions of the crucible 120 in the axial direction. This allows for more flexible adjustment of the radial temperature of the crucible 120, and also provides a larger adjustable temperature range.

In some embodiments, the fourth induction coil 1323 and/or the fifth induction coil 1324 may also be connected to an induction coil moving mechanism, thereby allowing the positions of the fourth induction coil 1323 and/or the fifth induction coil 1324 relative to the crucible 120 to be variable. For example, the fourth induction coil 1323 may be connected to a third induction coil moving mechanism, and the fifth induction coil 1324 may be connected to a fourth induction coil moving mechanism. The structure of the third induction coil moving mechanism and the structure of the fourth induction coil moving mechanism may be similar to the structure of the first induction coil moving mechanism.

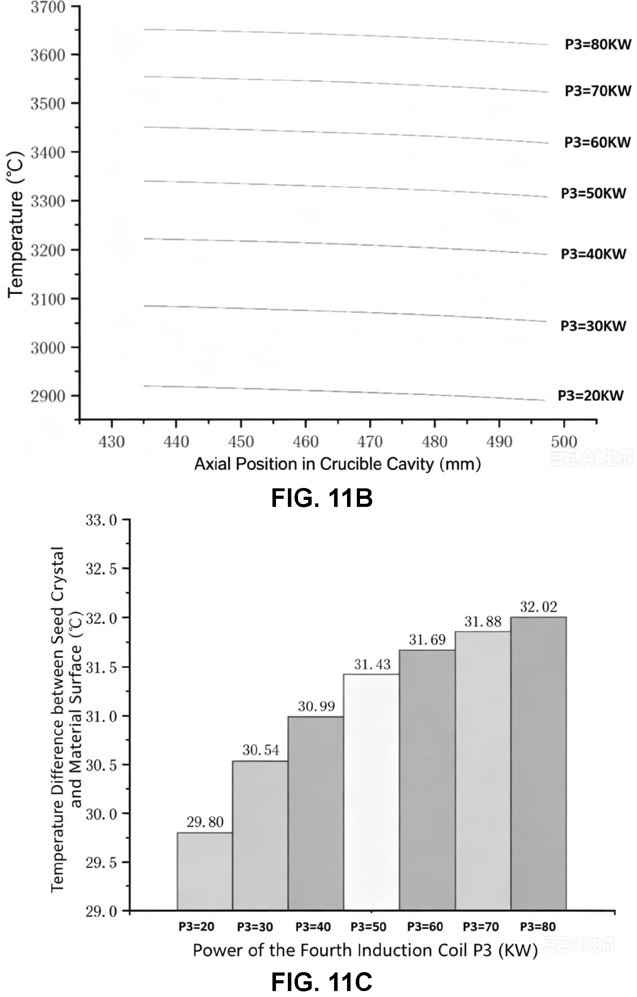

In some embodiments, by adjusting the power of the second induction coil 1321, the third induction coil 1322, the fourth induction coil 1323, and the fifth induction coil 1324, the temperature distribution inside the crucible 120 can be adjusted. More descriptions regarding specific details may be found elsewhere in the present disclosure (e.g., FIG. 11B and FIG. 11C and related descriptions thereof). FIG. 11B is a schematic diagram illustrating an axial temperature distribution of the inner cavity of the crucible corresponding to different power levels of the fourth induction coil and the fifth induction coil according to some embodiments of the present disclosure. In FIG. 11B, the horizontal axis represents an axial position in the inner cavity of the crucible 120, and the vertical axis represents the temperature (°C) in the inner cavity of the crucible 120. FIG. 11C is a schematic diagram illustrating the temperature difference between the seed crystal and the material surface, corresponding to different power levels of the fourth induction coil and the fifth induction coil according to some embodiments of the present disclosure. In FIG. 11C, the horizontal axis represents the power P3 of the fourth induction coil 1323 (the power P4 of the fifth induction coil 1324 = P3), and the vertical axis represents the temperature difference (°C) between the seed crystal and the material surface (the upper surface of the material inside the crucible 120). The power P1 of the second induction coil 1321 and the power P2 of the third induction coil 1322 are made equal, both being 50 kW, and the power P3 of the fourth induction coil 1323 and the power P4 of the fifth induction coil 1324 are made equal. The power P3 of the fourth induction coil 1323 and the power P4 of the fifth induction coil 1324 are adjusted to be equal and are respectively 20 kW, 30 kW, 40 kW, 50 kW, 60 kW, 70 kW, and 80 kW. An experimental group in which the power P1 of the second induction coil 1321, the power P2 of the third induction coil 1322, the power P3 of the fourth induction coil 1323, and the power P4 of the fifth induction coil 1324 are equal and all are 50 kW, is a control group. As can be seen from FIG. 11B, as the power P3 of the fourth induction coil 1323 and the power P4 of the fifth induction coil 1324 increase, the temperature inside the inner cavity of the crucible 120 gradually increases. As can be seen from FIG. 11C, when the power P3 of the fourth induction coil 1323 and the power P4 of the fifth induction coil 1324 are 80 kW, the temperature difference between the seed crystal and the material surface is the largest, and when the power is 20 kW, the temperature difference between the seed crystal and the material surface is the smallest; as the power P3 of the fourth induction coil 1323 and the power P4 of the fifth induction coil 1324 increase, the temperature difference between the seed crystal and the material surface also gradually increases. Based on FIG. 11B and FIG. 11C, it can be seen that the power of the induction coils (e.g., the fourth induction coil 1323 and the fifth induction coil 1324) may affect the overall temperature and the temperature gradient inside the crucible 120, and by adjusting the fourth induction coil 1323 and the fifth induction coil 1324, the overall temperature and the temperature gradient inside the crucible 120 can be adjusted.

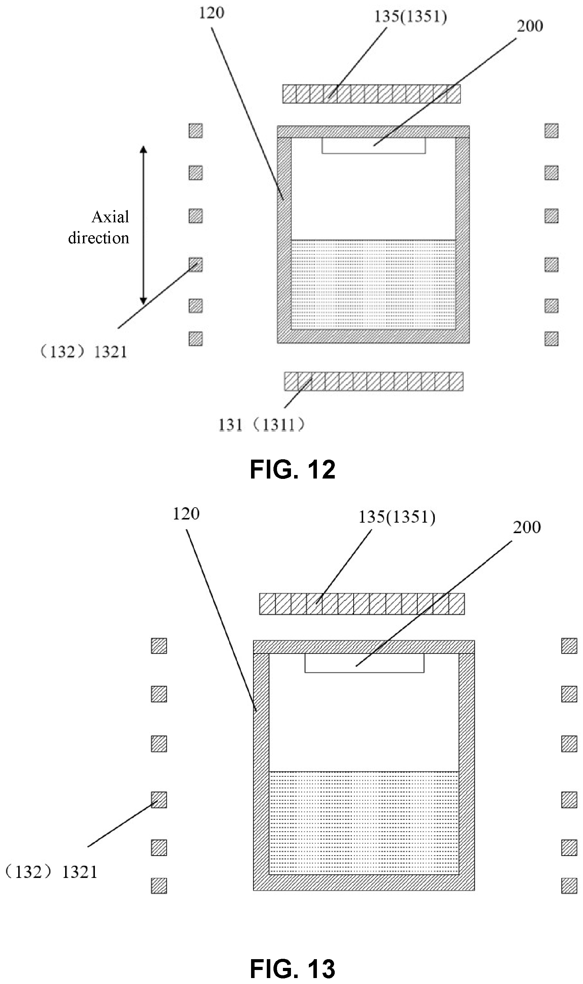

FIG. 12 is a schematic diagram illustrating an apparatus for crystal growth according to another embodiment of the present disclosure. As shown in FIG. 12, based on the above-mentioned embodiment, the heating assembly 130 further comprises a third heating assembly 135, and the third heating assembly 135 heats the top portion of the crucible 120. In the embodiment shown in FIG. 12, the heating assembly 130 comprises the first heating assembly 131, the second heating assembly 132, and the third heating assembly 135. It can be understood that the third heating assembly 135 may be arranged independently (not combined with the first heating assembly 131 and the second heating assembly 132), or the third heating assembly 135 may also be combined with any one of the first heating assembly 131 and the second heating assembly 132. The heating of the top portion of the crucible 120 by the third heating assembly 135 can be understood as meaning that the third heating assembly 135 is primarily configured to heat the top portion of the crucible 120, that is, the heat provided by the third heating assembly 135 to the top portion is higher than the heat provided by the third heating assembly 135 to other portions of the crucible (e.g., the side and the bottom). Through the combination of the third heating assembly 135 and the first heating assembly 131, the combination of the third heating assembly 135 and the second heating assembly 132, or the combination of the first heating assembly 131, the second heating assembly 132, and the third heating assembly 135, the crucible 120 can be heated from a plurality of different portions. The heating of various portions of the crucible 120 (e.g., bottom heating, side heating, and top heating) can be separately and independently controlled. This facilitates the adjustment of the temperature gradient (including the axial temperature gradient and the radial temperature gradient) within the inner cavity of the crucible 120.

In some embodiments, the third heating assembly 135 comprises a second resistance heater 1351 that provides heating via resistance heating. In some embodiments, the second resistance heater 1351 may be arranged to extend along a plane parallel to the upper cover of the crucible 120 and is spaced apart from the upper cover of the crucible 120. In some embodiments, the projection coverage area of the second resistance heater 1351 in the axial direction may be greater than or equal to the projection coverage area of the inner cavity of the crucible 120 in the axial direction, thereby allowing the heat radiation range of the second resistance heater 1351 to encompass the interior of the crucible 120. In some embodiments, to avoid an arcing phenomenon of resistance heating, the distance in the axial direction between the second resistance heater 1351 and the top wall of the crucible 120 may be greater than 20 mm (e.g., greater than 25 mm or greater than 30 mm). In some embodiments, the second resistance heater 1351 comprises resistance wires. More descriptions of the resistance wires in the second resistance heater 1351 may be found in the related descriptions of the resistance wires 13111. In some embodiments, the second resistance heater 1351 may be embedded in the top portion of the crucible 120.

In some embodiments, the third heating assembly 135 comprises an induction coil that heats via electromagnetic induction. Further descriptions of the induction coil included in the third heating assembly 135 may be found in the related descriptions of the first induction coil 1312. For example, a graphite ring may be arranged at the top portion of the crucible 120, and the induction coil of the third heating assembly 135 may at least partially surround the outside of the graphite ring at the top portion of the crucible 120.

In some embodiments, during the crystal growth stage, the third heating assembly 135 may also heat the crucible 120. In some embodiments, during the crystal growth stage, the ratio of side heat to top heat received by the material in the crucible is 1:3. In some embodiments, during the crystal growth stage, the ratio of bottom heat to top heat obtained by the material in the crucible is 1 to 8.

In some embodiments of the present disclosure, by targeted heating of the bottom portion, side portion, and top portion of the crucible 120, respectively by the first heating assembly 131, the second heating assembly 132, and the third heating assembly 135, the temperature distribution inside the crucible 120 is controlled and adjusted. In some embodiments, during the crystal growth stage, to ensure an optimal gas phase and temperature gradient (with the second heating assembly 132), the heat supplied by the heating assembly 130 to the crucible 120 (i.e., the heat obtained by the material 140 inside the crucible 120) is primarily provided by the first heating assembly 131 for bottom heating, and supplemented by the second heating assembly 132 for side heating and the third heating assembly 135 for top heating. In some embodiments, during the crystal growth stage, a ratio of bottom heat, side heat, and top heat is 8:3:1 to 1:1:1 (e.g., 5:3:1, 5:2:1, or 3:2:1). The bottom heat refers to the heat provided by the first heating assembly 131 and received by the bottom portion of the crucible 120; the side heat refers to the heat provided by the first heating assembly 131 or the second heating assembly 132 and received by the side portion of the crucible 120; and the top heat refers to the heat provided by the third heating assembly 135 and received by the top portion of the crucible 120. In some embodiments, an effective power ratio of the first heating assembly 131, the second heating assembly 132, and the third heating assembly 135 may be regarded as 8:3:1 to 1:1:1. In some embodiments, during the annealing stage, to minimize the radial temperature gradient inside the crystal, heating may be primarily provided by the first heating assembly 131 for bottom heating, and supplemented by the second heating assembly 132 for side heating, or only the first heating assembly 131 at the bottom portion of the crucible 120 is operated. In some embodiments, during the annealing stage, a ratio of bottom heat to side heat is 5:1 to 1.5:1 (e.g., 4:1, 3:1, or 2:1).

FIG. 13 is a schematic diagram illustrating an apparatus for crystal growth according to still another embodiment of the present disclosure. In some embodiments, as shown in FIG. 13, the apparatus for crystal growth 100 may comprise the second heating assembly 132 and the third heating assembly 135. By respectively arranging the second heating assembly 132 and the third heating assembly 135 at the side portion and the top portion of the crucible 120, respectively, the temperature distribution inside the crucible 120 is controlled and adjusted. In some embodiments, during the crystal growth stage, the second heating assembly 132 may be employed. If a higher inner cavity temperature of the crucible 120 is desired, the third heating assembly 135 may be used for assistance. In some embodiments, during the annealing stage, to minimize the radial temperature gradient inside the crystal, only the third heating assembly 135 at the top portion of the crucible 120 is operated, which can effectively reduce stress during a cooling process.

The present disclosure also provides a method for crystal growth. The method comprises: during the crystal growth stage, heating the crucible 120 by the first heating assembly 131 and the second heating assembly 132; and during the annealing stage, heating the crucible 120 by the second heating assembly 132 and the third heating assembly 135. During the crystal growth stage, to ensure an appropriate axial temperature gradient that drives the vapor-phase component to the crystal growth interface, a relatively ideal temperature gradient may be formed by the cooperation of the first heating assembly 131 and the second heating assembly 132. At this time, the third heating assembly 135 is not operating, and does not cause a reduction in the axial temperature gradient. During the annealing stage, to minimize an internal radial temperature gradient in the crystal, heating may be performed primarily by the third heating assembly 135 and secondarily by the second heating assembly 132.

In some embodiments, a crystal may include a SiC crystal. During the crystal growth process of the SiC crystal, graphite inclusions may be generated. At the initial stage of crystal growth, the internal chamber temperature is low, the pressure of the SiC vapor-phase component inside the crucible chamber is low, the growth rate is slow, and material graphitization has not yet started. As growth proceeds, the pressure of the vapor-phase component inside the crucible chamber gradually increases, and graphitization of the material begins. The fine particles after graphitization are highly likely to be carried to the growth surface by convection of the vapor phase component inside the crucible chamber, thereby generating graphite inclusions in the crystal. The presence of graphite inclusions may cause lattice distortion and generate stress, and may also induce defects such as micropipes, dislocations, or stacking faults, which severely affect the quality of the SiC product.

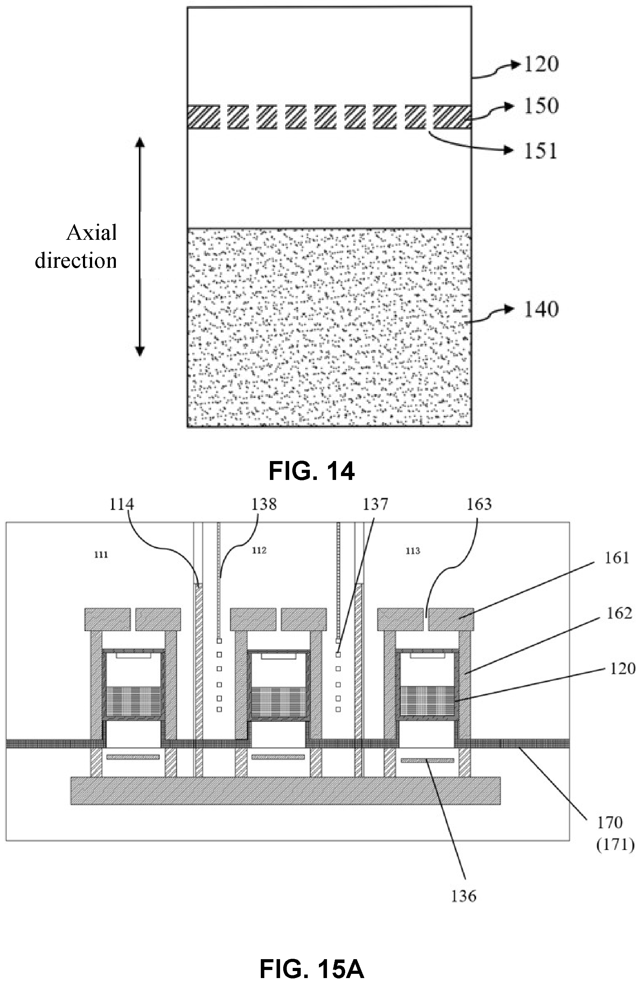

Therefore, in order to suppress the generation of the graphite inclusions, in some embodiments, the apparatus for crystal growth 100 includes a filtering structure arranged inside an inner cavity of the crucible. FIG. 14 is a schematic diagram illustrating a filtering structure according to some embodiments of the present disclosure.

In some embodiments, as shown in FIG. 14, the filtering structure 150 is located above a material 140 in the crucible 120 in the axial direction, and the filtering structure 150 includes the through-holes 151 penetrating the filtering structure 150 from top to bottom along the axial direction of the crucible 120. The filtering structure 150 may block the fine particles after carbonization from reaching the growth surface by convection of the vapor phase component inside the crucible 120 chamber, thereby avoiding the generation of graphite inclusions in the crystal. In some embodiments, a peripheral side of the filtering structure 150 is connected to an inner wall of the crucible 120, thereby separating the inner cavity of the crucible 120 along the axial direction. The through-holes may allow the vapor-phase component to pass, but the filtering structure 150 may block fine particles formed after graphitization from passing through, thereby suppressing the generation of graphite inclusions and homogenizing airflow transmission. It should be noted that the through-holes 151 in FIG. 14 are merely by way of example and are not intended as a description or limitation of their sizes.

In some embodiments, the porosity of the filtering structure 150 is within a range of 5%-40% (e.g., 10%-35%, 15%-25%), wherein porosity is the ratio of the aperture area to the surface area of the filtering structure 150. If the porosity of the filtering structure 150 is too large, it cannot achieve a good effect of suppressing the generation of the graphite inclusions. If the porosity of the filtering structure 150 is too small, it may affect the transmission of the vapor phase component. When the porosity of the filtering structure 150 is controlled within the range of 5%-40%, it can both suppress the formation of graphite inclusions and not affect the transmission of the vapor-phase component, thereby allowing a higher-quality crystal to be grown.

In some embodiments, an aperture size range of the through-holes 151 on the filtering structure 150 is 5 µm to 100 µm. In some embodiments, the aperture size range of the through-holes 151 on the filtering structure 150 is 5 µm to 80 µm. In some embodiments, the aperture size range of the through-holes 151 on the filtering structure 150 is 10 µm to 50 µm. It should be noted that the through-holes 151 in FIG. 14 are merely as an illustration, and do not represent their sizes. In some embodiments, the through-holes are arranged in an axially symmetric distribution on the filtering structure 150 (an axis of symmetry may be a diameter of the filtering structure 150), thereby allowing the airflow inside the crucible 120 chamber to be uniformly transmitted. In some embodiments, the through-holes are arranged in a rotationally symmetric distribution on the filtering structure 150, thereby uniformly transmitting the airflow within the chamber of the crucible 120. In some embodiments, the sizes and locations of the through-holes may be configured based on the enrichment distribution of graphite within the crucible 120 chamber. It is found that a peripheral region inside the chamber of the crucible 120 undergoes more severe carbonization (with more the fine particles after carbonization). The aperture size of the through-holes in an edge region of the filtering structure 150 is smaller than the aperture size of the through-holes 151 in the central region of the filtering structure 150, so as to better block the fine particles after carbonization from reaching the crystal. In some embodiments, the porosity of the through-holes 151 in the edge region of the filtering structure 150 is greater than the porosity of the through-holes 151 in the central region of the filtering structure. Because the aperture size of the through-holes 151 in the edge region of the filtering structure 150 is small, in order to avoid the edge region of the filtering structure 150 from hindering the transmission of the vapor phase component, the porosity of the through-holes 151 in the edge region of the filtering structure 150 is increased. This may both better suppress the generation of the graphite inclusions and ensure the temperature transmission of the vapor phase component.

In some embodiments, a material of the filtering structure 150 may be one that does not react with the vapor-phase component. In some embodiments, the material of the filtering structure 150 may comprise graphite. In some embodiments, the material of the filtering structure 150 may comprise one or more of tantalum, tungsten, titanium, and corresponding nitrides or carbides.

FIG. 15A is a schematic diagram illustrating an apparatus for crystal growth according to some embodiments of the present disclosure. As shown in FIG. 15A, the furnace chamber of the furnace body 110 comprises a plurality of chambers, and a plurality of crucibles 120 are respectively arranged in the plurality of chambers. Specifically, a crucible 120 is correspondingly arranged in a chamber. The apparatus for crystal growth 100 further comprises a conveying mechanism 170, wherein the conveying mechanism 170 is located in the furnace chamber, and the plurality of chambers are arranged along a conveying direction of the conveying mechanism 170. The conveying mechanism 170 moves the plurality of crucibles 120 between different chambers. In some embodiments, crystal growth in the crucibles 120 in different chambers may be in different stages. In some embodiments, temperatures in different chambers are different. In some embodiments, the conveying mechanism 170 may include a belt conveying mechanism 171, a chain drive mechanism, a push rod, a pull rod, or the like. A passage is arranged between adjacent chambers, allowing the crucible 120 to be capable of moving between different chambers. The conveying mechanism 170 may be arranged at a top portion, a bottom portion, or the like, of the furnace chamber. It should be noted that the conveying mechanism 170 being located in the furnace chamber may refer to the conveying mechanism 170 being completely located in the furnace chamber or may refer to a portion of the structure of the conveying mechanism 170 being located in the furnace chamber. The conveying mechanism 170 is capable of enabling the movement of the crucibles 120 between different chambers. Merely by way of example, two ends of the conveying direction of the belt conveying mechanism 171 may be located outside the furnace chamber.

In some embodiments, crystal growth in the crucibles in the plurality of chambers is in the same or different stages. In some embodiments, the number of the chambers is at least three. That is, the plurality of chambers comprises a first chamber 111, a second chamber 112, and a third chamber 113. The first chamber 111, the second chamber 112, and the third chamber 113 are arranged along the conveying direction. The maximum temperature in the second chamber 112 is higher than the maximum temperature in the first chamber 111, and the maximum temperature in the second chamber 112 is higher than the maximum temperature in the third chamber 113. The maximum pressure in the second chamber 112 is lower than the maximum pressure in the first chamber 111, and the maximum pressure in the second chamber 112 is lower than the maximum pressure in the third chamber 113. The temperature and pressure settings of the first chamber 111, the second chamber 112, and the third chamber 113 comply with a temperature and pressure change process during the crystal growth process, thereby allowing the respective chambers to match the temperature and pressure change process during the crystal growth process, which is beneficial for conveniently and efficiently growing the crystal.

Referring to the preceding related descriptions, because the crystal growth process may comprise a preheating stage, a crystal growth stage, and an annealing stage, at least three chambers may be respectively configured to correspond to the preheating stage, the crystal growth stage, and the annealing stage, thereby forming the first chamber 111, the second chamber 112, and the third chamber 113. In some embodiments, crystal growth in the crucibles 120 in the first chamber 111, the second chamber 112, and the third chamber 113 is in different stages. Crystal growth of the crucible 120 in the first chamber 111 is in the preheating stage, crystal growth of the crucible 120 in the second chamber 112 is in the crystal growth stage, and crystal growth of the crucible 120 in the third chamber 113 is in the annealing stage. The temperature range within the crucible 120 of the first chamber 111 refers to the temperature range within the crucible 120 corresponding to the preheating stage; the temperature range within the crucible 120 of the second chamber 112 refers to the temperature range within the crucible 120 corresponding to the crystal growth stage; and the temperature range within the crucible 120 of the third chamber 113 refers to the temperature range within the crucible 120 corresponding to the annealing stage.

By corresponding the setting of the chambers with the stages of crystal growth, each crucible 120 may be in the corresponding chamber during the various stages of crystal growth within the crucible 120, and the movement of the crucible 120 between different chambers can be conveniently completed by the conveying mechanism. The temperature within the chamber only needs to be set to the temperature corresponding to the crystal growth stage and may be adjusted within the temperature range corresponding to the crystal growth stage. This may simultaneously perform crystal growth of the plurality of crucibles 120, and for a single chamber, there is no need for frequent heating and cooling, thereby realizing the continuous production of crystals and greatly improving the output efficiency of the crystals.

According to some embodiments of the present disclosure, an openable partition 114 is arranged between two adjacent chambers, and the openable partition 114 may insulate the two adjacent chambers. According to some embodiments of the present disclosure, the openable partition 114 may open or close the passage between the two adjacent chambers. When the openable partition 114 is closed, the two adjacent chambers are insulated, thereby preventing the pressure and the temperature between the two adjacent chambers from affecting each other. When the crucible 120 needs to be moved, the openable partition 114 may be opened, allowing the crucible 120 to pass through and preventing the openable partition 114 from affecting the movement of the crucible 120.

According to some embodiments of the present disclosure, any one type of heating assembly 130 as shown in FIG. 2 to FIG. 13 may be employed within the first chamber 111, the second chamber 112, and the third chamber 113 to heat the crucible 120. According to some embodiments of the present disclosure, the heating assembly 130 includes a plurality of third resistance heaters 136, and the plurality of third resistance heaters 136 are respectively arranged in the plurality of chambers. Specifically, a third resistance heater 136 is correspondingly arranged in a chamber. The third resistance heater 136 is located at the bottom portion of one of the plurality of crucibles 120, configured to heat the bottom portion of the crucible 120.

According to some embodiments of the present disclosure, the third resistance heater 136 is arranged below the conveying mechanism 171 in an axial direction. The distance between the third resistance heater 136 and the conveying mechanism 171 in the axial direction of the crucible 120 is within a range of 10 mm to 30 mm (e.g., 25 mm, 20 mm, or 15 mm).

According to some embodiments of the present disclosure, the heating assembly 130 includes at least one sixth induction coil 137 arranged in at least one chamber. The sixth induction coil 137 is arranged around the crucible 120, located on the side portion of the crucible 120, and configured to heat the side of the crucible 120. According to some embodiments of the present disclosure, because the crystal growth stage has higher temperature requirements for the crucible 120 (if both the axial temperature gradient and the radial temperature gradient within the crucible 120 have high requirements), the sixth induction coil 137 is arranged in the second chamber 112, arranged around the crucible 120 within the second chamber 112, configured to heat the side of the crucible 120 within the second chamber 112, thereby increasing the temperature within the crucible 120. According to some embodiments of the present disclosure, to prevent the sixth induction coil 137 from affecting the conveying mechanism from conveying the crucible 120, the heating assembly 130 includes at least one coil lifting device 138 arranged in the chamber where the sixth induction coil 137 is located, and the coil lifting device 138 is capable of lifting the sixth induction coil 137 along an axial direction. According to some embodiments of the present disclosure, when the sixth induction coil 137 is arranged in the second chamber 112, the coil lifting device 138 is also correspondingly arranged in the second chamber 112. In addition, the coil lifting device 138 may also adjust an axial position of the sixth induction coil 137 relative to the crucible 120 that the sixth induction coil 137 is arranged around, thereby adjusting a temperature distribution (e.g., an axial temperature gradient) within the corresponding crucible 120. The structure of the coil lifting device 138 may be similar to the first induction coil moving mechanism 60 described above. More descriptions regarding the specific implementation may be found in the preceding related descriptions.

According to some embodiments of the present disclosure, the apparatus for crystal growth further includes a plurality of thermal insulation structures 160, and the plurality of thermal insulation structures 160 are respectively arranged in the plurality of chambers. The plurality of thermal insulation structures 160 are arranged outside the plurality of crucibles 120 in a one-to-one correspondence. The thermal insulation structure 160 is arranged to enclose the crucible 120, configured to insulate the crucible 120. According to some embodiments of the present disclosure, the thermal insulation structure 160 includes a top insulating part 161 and a side insulating part 162, wherein the top insulating part 161 is located at the top portion of the crucible 120, and the side insulating part 162 is located at the side portion of the crucible 120. According to some embodiments of the present disclosure, the top end of the side insulating part 162 in an axial direction is connected to the top insulating part 161. According to some embodiments of the present disclosure, a temperature measuring opening 163 is arranged on the top insulating part 161, the temperature measuring opening 163 penetrates the top insulating part 161, and the temperature measuring opening 163 is configured for a thermometer to extend into for temperature measurement. According to some embodiments of the present disclosure, the temperature measured by the thermometer extending into the temperature measuring opening 163 refers to the temperature of the top of the upper cover 121 of the crucible 120. According to some embodiments of the present disclosure, the thermometer extending into the temperature measuring opening 163 may be arranged in a retractable manner. For example, the thermometer itself may be a retractable structure, or the thermometer may be connected to a retractable structure. That is, when temperature measurement is needed, the retractable structure extends, and the thermometer extends into the temperature measuring opening 163; when the conveying mechanism 170 conveys the crucible 120, the retractable structure retracts, and the thermometer leaves the temperature measuring opening 163.

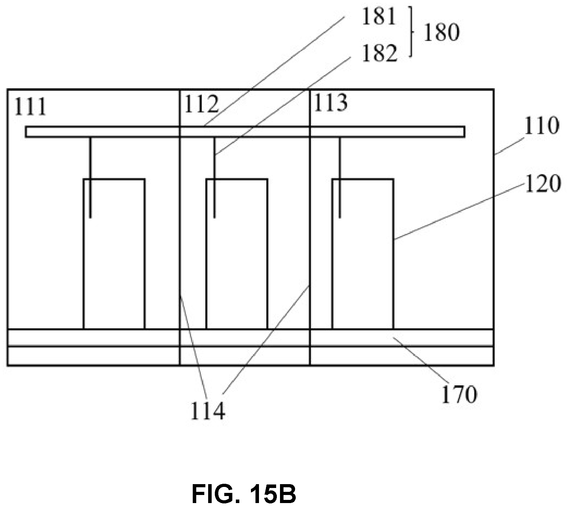

According to some embodiments of the present disclosure, the apparatus for crystal growth 100 includes the plurality of chambers, in which temperature measurement and pressure measurement may be performed separately, to facilitate separately controlling the temperature and the pressure within each chamber. According to some embodiments of the present disclosure, equipment configured to sense temperature and pressure is separately arranged in each chamber. FIG. 15B is a schematic diagram illustrating an apparatus for crystal growth according to some embodiments of the present disclosure. As shown in FIG. 15B, according to some embodiments of the present disclosure, the apparatus for crystal growth includes a first temperature measuring assembly 180. The first temperature measuring assembly 180 includes a first electrical rail 181 and a plurality of first thermometers 182. The plurality of first thermometers 182 respectively measure temperatures in the inner cavities of the plurality of crucibles 120. The first electrical rail 181 is arranged outside the crucibles 120, and a portion of each first thermometer 182 of the plurality of first thermometers 182 extending out of the crucible 120 is in sliding electrical contact with the first electrical rail 181. The first electrical rail 181 is parallel to the conveying direction of the conveying mechanism 170. The first electrical rail 181 is located within the furnace chamber and extends through the plurality of chambers. When the conveying mechanism 170 conveys the crucible 120, the first thermometer 182 will move synchronously with the crucible 120. The first thermometer 182 is in sliding electrical contact with the first electrical rail 181, thereby allowing the first electrical rail 181 to provide power to the first thermometer 182 in real time. According to some embodiments of the present disclosure, the temperature signal detected by the first thermometer 182 may be outputted through the first electrical rail 181. Through such a setting, the first thermometer 182 may continuously perform temperature measurement during the process where the crucible 120 is conveyed by the conveying mechanism 170, and the measured temperature may also be conveniently transmitted out.

According to some embodiments of the present disclosure, the first thermometer is fixed at the temperature measuring opening 163 for temperature measurement. The first electrical rail is located at the upper portion of the crucible 120 in the axial direction. Specifically, the first thermometer is maintained within the temperature measuring opening 163, and a portion extending out of the temperature measuring opening 163 is maintained in sliding electrical contact with the first electrical rail. When the crucible 120 is conveyed by the conveying mechanism 170, the first thermometer slides relative to the first electrical rail, maintaining monitoring of the temperature during the movement of the crucible 120. According to other embodiments of the present disclosure, the first thermometer may be fixed on the sidewall or the bottom wall of the crucible 120, and the first thermometer extends out from the sidewall or the bottom wall of the crucible 120. This may facilitate measuring the temperature of the material within the crucible 120. According to some embodiments of the present disclosure, a sealing structure may be arranged at the position where the first thermometer extends out from the sidewall or the bottom wall of the crucible 120.

According to some embodiments of the present disclosure, a pressure control mechanism may be separately arranged in each chamber (e.g., the first chamber 111, the second chamber 112, and the third chamber 113) to separately control the pressure within each chamber. According to some embodiments of the present disclosure, the pressure control mechanism may include a butterfly valve, a mechanical pump, or the like.

Merely by way of example, the transfer of the crucible 120 among the plurality of chambers is described. Inside the first chamber 111, the temperature may be raised to a first preset temperature (e.g., 1900°C to 2000°C) under a first preset pressure (e.g., a high pressure of 40 KPa to 80 KPa). The pressure in the second chamber 112 is raised to be consistent with the first chamber 111, and the temperature inside the second chamber 112 is controlled within a second preset temperature range (e.g., 1900°C to 2100°C). After the conveying mechanism 170 conveys the crucible 120 to the second chamber 112, depressurization growth is initiated. Inside the second chamber 112, depressurization may be rapidly performed to a second preset pressure (e.g., 1 KPa to 1.2 KPa) at a rate of 50 KPa/h to 60 KPa/h. Inside the second chamber 112, crystal growth may occur for a certain period of time under the second preset pressure. During the crystal growth stage, the temperature inside the second chamber 112 may slowly increase to a third preset temperature (e.g., 2100°C to 2400°C). Furthermore, the first chamber 111 needs to cool down. When 10 hours remain until the end of the crystal growth stage for the crucible 120 in the second chamber 112, the first chamber 111 is opened, and another crucible 120 is placed therein for heating. After the crystal growth stage for the crucible 120 in the second chamber 112 ends, the crucible 120 in the second chamber 112 is conveyed to the third chamber 113. Simultaneously with the crucible in the second chamber 112 being conveyed to the third chamber 113, the other crucible 120 in the first chamber 111 is conveyed to the second chamber 112 to continue growth. In the third chamber 113, the crucible 120 undergoes in-situ annealing. Specifically, in the third chamber 113, the pressure is raised to a third preset pressure (e.g., a high pressure of 40 KPa to 80 KPa), and cooling is performed at a certain cooling rate (e.g., 1°C/min to 3°C/min). When the in-situ annealing for the crucible 120 in the third chamber 113 ends, the third chamber 113 is opened, and the crucible 120 is taken out. In the above manner, a sequential circulation of the crucible 120 may be achieved.

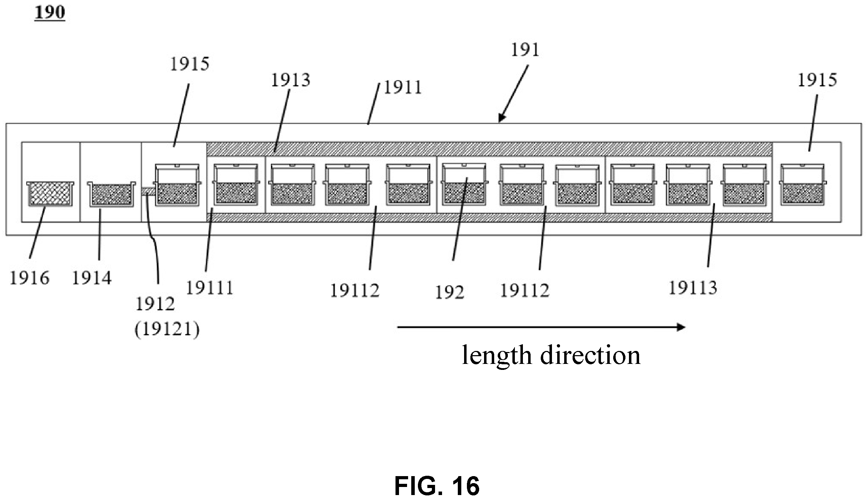

In some embodiments, the apparatus for crystal growth 100 further comprises a material preparation assembly. FIG. 16 is a schematic diagram illustrating the material preparation assembly according to some embodiments of the present disclosure. As shown in FIG. 16, the apparatus for crystal growth 100 further comprises a material preparation assembly 190. The material preparation assembly 190 comprises a tunnel furnace 191 and a plurality of raw material furnaces 192.

The tunnel furnace 191 refers to an apparatus in which a material preparation process is centrally arranged. The tunnel furnace 191 refers to a furnace body configured to provide a chamber with a relatively long length, and in the chamber, an object may move along the relatively long length direction (hereinafter referred to as the length direction of the tunnel furnace 191). In some embodiments, the tunnel furnace 191 comprises a heating chamber 1911, and the plurality of raw material furnaces 192 are disposed inside the heating chamber 1911. The heating chamber 1911 may be formed inside the chamber of the tunnel furnace 191. A fourth heating assembly is disposed inside the heating chamber 1911. The fourth heating assembly is configured to heat the raw material furnaces 192 in the heating chamber 1911. The fourth heating assembly may heat the raw material furnaces 192 in the heating chamber to provide the raw material furnaces 192 with a temperature required for material preparation. The raw material furnace 192 is configured to provide a place for material generation. In some embodiments, the raw material furnace 192 comprises a main body 1921 and an upper cover 1922. The main body 1921 forms a receiving chamber to receive a raw material for preparing a material. In some embodiments, the raw materials for preparing a material may include carbon powder and silicon powder. The carbon powder and the silicon powder are mixed in the raw material furnace 192 to prepare and produce SiC material.

In some embodiments, the plurality of raw material furnaces 192 are sequentially disposed inside the heating chamber 1911 along the length direction of the tunnel furnace 191 (e.g., FIG. 16). In some embodiments, the tunnel furnace 191 comprises a movement driving mechanism 1912. The movement driving mechanism 1912 is capable of driving the plurality of raw material furnaces 192 to move along the length direction of the tunnel furnace 191. The movement driving mechanism 1912 may achieve conveying of the raw material furnaces 192 in the tunnel furnace 191. Through an arrangement of the heating chamber 1911, the fourth heating assembly, and the movement driving mechanism 1912, the raw material furnaces 192 may be heated in the tunnel furnace 191. The fourth heating assembly may control the temperature of the heating chamber. In cooperation with the movement driving mechanism 1912, the fourth heating assembly controls the conveying speed and the residence time of the raw material furnaces 192 within the tunnel furnace 191, thereby controlling the temperature and heating time of the raw material furnaces 192, and thus precisely achieving a preparation of the material. And because the tunnel furnace 191 is provided, the plurality of raw material furnaces 192 may be simultaneously heated and sequentially conveyed out of the tunnel furnace 191. In addition, after a material with completed preparation is taken out of the raw material furnace 192, raw materials may be placed into the raw material furnace 192 again, and the raw material furnace 192 may be cyclically sent into the tunnel furnace 191 again, thereby achieving cyclic material preparation and greatly improving an efficiency of material preparation.

In some embodiments, the movement driving mechanism 1912 comprises a conveyor belt mechanism. The conveyor belt mechanism is arranged along the length direction of the tunnel furnace 191. The raw material furnaces 192 are placed on the conveyor belt mechanism, and the conveyor belt mechanism drives the plurality of raw material furnaces 192 to move along the length direction of the tunnel furnace 191. In some embodiments, the plurality of raw material furnaces 192 are connected in sequence. The movement driving mechanism 1912 comprises a push rod 19121 or a pull rod. The push rod 19121 or the pull rod is connected to one raw material furnace of the plurality of raw material furnaces 192. When the push rod 19121 pushes or the pull rod pulls one of the plurality of raw material furnaces 192, the movement driving mechanism 1912 is capable of driving the plurality of raw material furnaces 192 to move together. In some embodiments, the push rod 19121 or the pull rod is disposed on one side of the entire plurality of raw material furnaces 192. The push rod 19121 or the pull rod is connected to the raw material furnace 192 closest to the push rod 19121 or the pull rod. The movement driving mechanism 1912 adopts the push rod 19121 or the pull rod, which is simple in structure and can withstand a high temperature inside the heating chamber 1911, thereby reducing the failure rate.

In some embodiments, in order to reduce heat dissipation in the heating chamber 1911, the tunnel furnace 191 further comprises an insulating layer 1913. The insulating layer 1913 insulates the heating chamber 1911. The insulating layer 1913 may be disposed inside the heating chamber 1911 (e.g., attached to an inner wall of the heating chamber 1911) or may be disposed outside the heating chamber 1911 (e.g., wrapped around the tunnel furnace 191). The insulating layer 1913 may include insulating felt, insulating coating, or the like. For example, the insulating layer 1913 may be an insulating coating coated on an inner wall of the heating chamber 1911 (which may include a top wall, a bottom wall, and a side wall). Another example, the insulating layer 1913 may be an insulating felt wrapped around the tunnel furnace 191 at a position corresponding to where the heating chamber 1911 is located.

In some embodiments, the heating chamber 1911 sequentially comprises a preheating section 19111, a heating section 19112, and a cooling section 19113 along the length direction of the tunnel furnace 191. The preheating section 19111, the heating section 19112, and the cooling section 19113 are separated from each other. The maximum temperature in the heating section 19112 is higher than the maximum temperature in the preheating section 19111, and the maximum temperature in the heating section 19112 is higher than the maximum temperature in the cooling section 19113. That is to say, the tunnel furnace 191 is separated into at least three sections along the length direction, and the heating temperatures for the raw material furnaces 192 in the at least three sections may be different. Because during the material preparation process, heating of the raw materials in the raw material furnaces 192 will undergo three stages, namely, a preheating stage, a heating stage, and a cooling stage.

During the preheating stage, because the raw material furnace 192 is placed in the heating chamber 1911, the temperature inside the raw material furnace 192 continuously or gradually rises from room temperature to reach or approach (below) a first preset temperature. In some embodiments, the first preset temperature may be 2000°C to 2200°C. During the heating stage, the temperature inside the raw material furnace 192 further increases, and after reaching the second preset temperature, insulation starts. In some embodiments, the second preset temperature may be 2050°C to 2300°C. During the cooling stage, the temperature inside the raw material furnace 192 starts to continuously or gradually decrease.

In some embodiments, the preheating section 19111 has a temperature of room temperature to 2000°C, and the heating section 19112 may have a temperature of 2000°C to 2300°C. In some embodiments, the dwell time of the raw material furnace 192 in the preheating section 19111 may be 5 to 10 h. In some embodiments, the dwell time of the raw material furnace 192 in the heating section 19112 may be 10 to 50 h. In some embodiments, the cooling section 19113 has a temperature of 2300°C to 800°C, and the dwell time of the raw material furnace 192 in the cooling section 19113 may be 20 h to 50 h.

The movement driving mechanism 1912 is configured to convey the plurality of raw material furnaces 192 according to a preset time, thereby controlling the dwell time of the raw material furnaces 192 in each of the sections (the preheating section 19111, the heating section 19112, and the cooling section 19113), so as to achieve temperature control during a material preparation process. With such a configuration, material preparation may be performed cyclically in the plurality of raw material furnaces 192, thereby achieving high material preparation efficiency.

In some embodiments, the fourth heating assembly may be arranged in the preheating section 19111 and the heating section 19112 of the heating chamber 1911, and the fourth heating assembly is configured to heat the raw material furnaces 192 in the preheating section 19111 and the heating section 19112. It should be noted that the preheating of the preheating section 19111 and the heating of the heating section 19112 are merely directed to a preparation stage of the raw material, and do not represent a limitation on the temperatures of the preheating section 19111 and the heating section 19112. That is to say, the temperature of the preheating section 19111 may be higher than, equal to, or lower than the temperature of the heating section 19112, and the temperatures of the preheating section 19111 and the heating section 19112 may be set based on preparation requirements for the raw material. In other embodiments, the fourth heating assembly may include a first heating component. The first heating component may be arranged in the preheating section 19111 and the heating section 19112, and the first heating component may collectively heat the preheating section 19111 and the heating section 19112. At this time, according to the arrangement location of the first heating component, in some embodiments, the fourth heating assembly may include a second heating component and a third heating component. The second heating component may be arranged in the preheating section 19111, and the third heating component may be arranged in the heating section 19112. Such a configuration may allow for more flexible control over the temperatures of the preheating section 19111 and the heating section 19112. In some embodiments, the fourth heating assembly may further include a fourth heating component. The fourth heating component may be arranged in the cooling section, and by controlling the heating temperature of the fourth heating component within the cooling section, the cooling rate of the material synthesized in the raw material furnaces may be controlled. In some embodiments, the movement driving mechanism 1912 may control the dwell time of each of the raw material furnaces 192 in the preheating section 19111 and the heating section 19112. Furthermore, by cooperating with the heating temperatures of the fourth heating assembly, the heat obtained by each of the raw material furnaces may be controlled, thereby satisfying requirements for material preparation.

In some embodiments, the tunnel furnace 191 may be provided with a plurality of pressure control mechanisms configured to respectively control the pressures of the preheating section 19111, the heating section 19112, and the cooling section 19113. In some embodiments, the pressure control mechanism may include a butterfly valve, a mechanical pump, or the like.

In some embodiments, each of the preheating section 19111, the heating section 19112, and the cooling section 19113 is provided with a first temperature measuring mechanism and a first pressure measuring mechanism, configured to respectively measure the temperatures and the pressures in the preheating section 19111, the heating section 19112, and the cooling section 19113, thereby facilitating individual control over temperatures and pressures within each region. That is to say, the tunnel furnace 191 may include a plurality of first temperature measuring mechanisms and a plurality of first pressure measuring mechanisms. The plurality of first temperature measuring mechanisms are arranged at the positions in the heating chamber 1911 corresponding to different sections (the preheating section 19111, the heating section 19112, and the cooling section 19113), and the plurality of first pressure measuring mechanisms are arranged at the positions in the heating chamber 1911 corresponding to different sections (the preheating section 19111, the heating section 19112, and the cooling section 19113). In some embodiments, the first temperature measuring mechanism may include an infrared thermometer.

In some embodiments, the tunnel furnace 191 includes a second temperature measuring assembly, which is capable of measuring the temperature in each of the plurality of raw material furnaces 192. By virtue of such a configuration, an operator may obtain knowledge of the temperature in each of the raw material furnaces, thereby facilitating the operator's understanding of temperature conditions in each of the raw material furnaces 192 during a raw material production process.

In some embodiments, the second temperature measuring assembly includes a second electrical rail and a plurality of second thermometers. The plurality of second thermometers respectively measure the temperatures in the plurality of raw material furnaces 192 via portions extending into the raw material furnaces 192. The second electrical rail is arranged outside the raw material furnaces 192, and a portion of each second thermometer of the plurality of second thermometers extending out of one of the raw material furnaces 192 is in sliding electrical contact with the second electrical rail. The second electrical rail is parallel to the length direction of the tunnel furnace 191. In some embodiments, the second electrical rail is located in the heating chamber 1911 to prevent the second thermometers from extending out of the heating chamber 1911 and damaging the temperature field in the heating chamber. Specifically, the second thermometers continue to measure the temperature in the raw material furnaces 192 and maintain sliding electrical contact with the second electrical rail. When the raw material furnaces 192 move under the drive of the movement driving mechanism 1912, the second thermometers in the raw material furnaces 192 also move accordingly, and the second thermometers slide relative to the second electrical rail, thereby maintaining temperature monitoring during movement of the raw material furnaces 192. The structure, function, or the like of the second temperature measuring assembly may be similar to that of the first temperature measuring assembly 180. The only difference is that the second temperature measuring assembly measures the temperature in the raw material furnaces 192. More descriptions regarding the second temperature measuring assembly may be found elsewhere in the present disclosure (e.g., related descriptions of the first temperature measuring assembly 180).

In some embodiments, the tunnel furnace 191 further includes a cooling mechanism arranged outside the heating chamber 1911. The cooling mechanism may perform cooling for the entire tunnel furnace 191 via water cooling, air cooling, or the like. Merely by way of example, a water cooling pipe may be wound on a furnace wall of the tunnel furnace 191. The cooling mechanism is configured to prevent the tunnel furnace 191 from reaching excessively high temperatures during the heating process, thereby avoiding hazards. In some embodiments, since the temperatures of the preheating section 19111 and the heating section 19112 are relatively high, a furnace body portion of the tunnel furnace 191 corresponding to the preheating section 19111 and the heating section 19112 is provided with the cooling mechanism. In some embodiments, the cooling mechanism includes a double-layer water cooling structure. An inlet of the water cooling structure is equipped with a water flow sensor, and an outlet is equipped with a water temperature sensor, to monitor the water flow rate and the temperature of the cooling water in real time, thereby ensuring safety.

In some embodiments, the tunnel furnace 191 further includes a mixing chamber 1916, a compacting chamber 1914, and a pre-vacuum chamber 1915. The mixing chamber 1916 is configured to mix raw materials (e.g., carbon powder and silicon powder); the compacting chamber 1914 is configured to compact the raw materials; and the pre-vacuum chamber 1915 is configured to extract air from the raw material furnaces 192. In some embodiments, the mixing chamber 1916 includes a mixing barrel and a rotating device. The mixing chamber 1916 integrally rotates the mixing barrel to mix the material within the mixing barrel. In some embodiments, the compacting chamber 1914 compacts the material by adopting hydraulic technology (e.g., a hydraulic hammer) or other means. In some embodiments, the pre-vacuum chamber 1915 is provided with a vacuum gauge and may perform real-time monitoring of a vacuum degree and the pressure in the raw material furnaces 192. By pre-evacuating the raw material furnaces 192, it may be possible to avoid the danger of explosion caused by heating the raw materials in subsequent steps. In some embodiments, the mixing chamber 1916 further includes a pressure relief device. Since the raw materials (e.g., carbon powder and silicon powder) form a high pressure within the mixing chamber after being subjected to high-speed rotation in the mixing chamber, the pressure relief device is utilized to restore the air pressure within the mixing chamber 1916 to atmospheric pressure, thereby ensuring safety during a production process. In some embodiments, the mixing chamber includes a weighing device. By using a weighing device, it may be more convenient to determine the weights of various raw materials, thereby ensuring the accuracy of their ratios.

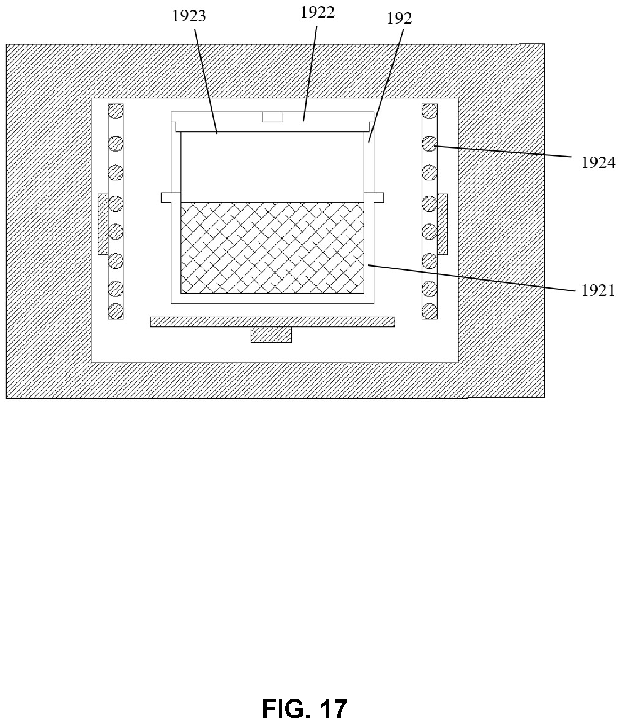

FIG. 17 is a schematic diagram illustrating an exemplary raw material furnace according to some embodiments of the present disclosure. In some embodiments, the raw material furnace 192 may be configured to produce lump material. As shown in FIG. 17, the raw material furnace 192 includes a main body 1921 and an upper cover 1922. The upper cover 1922 is provided with a seed crystal bonding surface 1923, and the seed crystal is bonded on the seed crystal bonding surface 1923. The raw material for producing the material is placed in the bottom portion of the raw material furnace 192. By controlling a temperature field distribution within the raw material furnace 192, the material continuously sublimates and is consumed, thereby allowing crystal material to grow on the seed crystal. Specifically, by controlling the temperature field distribution within the raw material furnace 192, an axial temperature gradient is formed between the raw material and the seed crystal on the seed crystal bonding surface 1923. The material placed in the bottom of the raw material furnace 192 sublimates into the gaseous component under high temperature conditions, and the gaseous component is transported to the seed crystal in a low temperature zone under the drive of the axial temperature gradient. Since the temperature at a position where the seed crystal is located is relatively low, the gaseous component may form crystal material on the surface of the seed crystal. The crystal material may be broken to form a lump material, and the lump material may be used as a raw material for crystal growth via the PVT manner.

In some embodiments, the seed crystal bonding surface 1923 may be a graphite material. In some embodiments, the seed crystal bonding surface 1923 is an inner side surface of the upper cover 1922, and the seed crystal may be fixedly bonded to the seed crystal bonding surface 1923. In some embodiments, a seed crystal 200 may be fixed on the seed crystal bonding surface 1923 by the adhesive. The adhesive may include, but is not limited to, epoxy resin adhesive, AB adhesive, phenolic resin adhesive, sugar glue, or the like.

In some embodiments, the fourth heating assembly 1924 is arranged outside the raw material furnace 192, and is configured to heat the raw material furnace 192. In some embodiments, the fourth heating assembly 1924 may heat a side portion of the raw material furnace 192. For example, the fourth heating assembly 1924 is a heating tube arranged around the side portion of the raw material furnace 192. In some embodiments, a plurality of fourth heating assemblies 1924 are provided, and the plurality of fourth heating assemblies 1924 are respectively arranged around a plurality of raw material furnaces 192. This may allow for more precise control of the temperature in each raw material furnace 192, thereby providing a better heating effect. In some embodiments, the fourth heating assembly 1924 may be arranged at a bottom portion of the raw material furnace 192. This may form a larger axial temperature gradient in the raw material furnace 192, thereby facilitating the transport of the sublimed raw material. For example, the fourth heating assembly 1924 may be a resistance heater arranged at the bottom portion of the raw material furnace 192. More descriptions regarding the arrangement of the fourth heating assembly outside the raw material furnace 192 may be found elsewhere in the present disclosure (e.g., the arrangement of the heating assembly outside the crucible 120 as shown in FIGs. 2 to 13 and related descriptions thereof). In some embodiments, each raw material furnace 192 is provided with a second temperature measuring mechanism and a second pressure measuring mechanism configured to individually measure the temperature and the pressure in each raw material furnace 192, thereby facilitating individual control of the temperature and the pressure in each raw material furnace 192. Since each raw material furnace 192 is provided with the corresponding fourth heating assembly 1924, the conditions within each raw material furnace 192 may be different, and the second temperature measuring mechanism and the second pressure measuring mechanism may better detect the temperature and the pressure within each raw material furnace 192.

It should be noted that beneficial effects that may be generated by different embodiments may be different. In various embodiments, the beneficial effects that may be generated may be any one or a combination of several of the foregoing, or any other beneficial effects that may be obtained.

The basic concepts have been described above. Obviously, for those skilled in the art, the detailed disclosure described above is merely by way of example, and does not constitute a limitation on the present disclosure. Although not explicitly stated herein, those skilled in the art may make various modifications, improvements, and alterations to the present disclosure. Such modifications, improvements, and alterations are suggested in the present disclosure, and therefore still fall within the spirit and scope of the exemplary embodiments of the present disclosure.

Finally, it should be understood that the embodiments described in the present disclosure are merely for illustrating the principles of the embodiments of the present disclosure. Other variations may also fall within the scope of the present disclosure. Therefore, by way of example and not limitation, alternative configurations of the embodiments of the present disclosure may be regarded as consistent with the teachings of the present disclosure. Accordingly, the embodiments of the present disclosure are not limited to the embodiments explicitly introduced and described in the present disclosure.

## Claims

1. An apparatus for crystal growth, comprising a furnace body, a crucible, and a heating assembly, wherein the furnace body comprises a furnace chamber, the crucible and the heating assembly are both disposed within the furnace chamber, and the heating assembly is configured to heat the crucible.

2. The apparatus for crystal growth according to claim 1, wherein the heating assembly comprises at least one of a first heating assembly or a second heating assembly, wherein the first heating assembly heats a bottom portion of the crucible; and the second heating assembly heats a side portion of the crucible.

3. The apparatus for crystal growth according to claim 2, wherein the second heating assembly comprises a second induction coil; and the second induction coil is arranged around a sidewall of the crucible;
the first heating assembly comprises a first induction coil, and the first induction coil is arranged around a bottom wall of the crucible; or,
the first heating assembly comprises a first resistance heater, and the first heating assembly is arranged below the bottom wall of the crucible.

4. The apparatus for crystal growth according to claim 3, wherein a graphite ring is arranged at a bottom portion of the crucible, and the first induction coil is at least partially arranged around an outside of the graphite ring; or
the first resistance heater is embedded inside the bottom wall of the crucible.

5. The apparatus for crystal growth according to claim 4, wherein an annular baffle is arranged between the first induction coil and the second induction coil, and the annular baffle is arranged around the crucible.

6. The apparatus for crystal growth according to claim 3, wherein the heating assembly further comprises a third heating assembly, and the third heating assembly heats a top portion of the crucible.

7. The apparatus for crystal growth according to claim 6, wherein the third heating assembly comprises a second resistance heater.

8. The apparatus for crystal growth according to claim 7, wherein a distance between the first resistance heater and the crucible, and a distance between the second resistance heater and the crucible are both greater than 20 mm; and/or,
at least one of the first resistance heater or the second resistance heater comprises resistance wires, and a minimum interval distance between the resistance wires is within a range of 10 mm-15 mm.

9. The apparatus for crystal growth according to claim 6, wherein during a crystal growth stage, a ratio of bottom heat to side heat obtained by a material in the crucible is 1-4, and a ratio of side heat to top heat is 1-3; during an annealing stage, a ratio of top heat and side heat obtained by the material in the crucible is within a range of 1.5-5, wherein the bottom heat is provided by the first heating assembly, the side heat is provided by the second heating assembly, and the top heat is provided by the third heating assembly.

10. The apparatus for crystal growth according to claim 3, wherein the second heating assembly further comprises a third induction coil, and the third induction coil is sleeved on an outside of the second induction coil.

11. The apparatus for crystal growth according to claim 10, wherein a power of the first induction coil is greater than a power of the second induction coil.

12. The apparatus for crystal growth according to claim 10, wherein the apparatus further comprises:
a first induction coil moving mechanism, configured to drive the second induction coil to move along an axial direction of the crucible, the first induction coil moving mechanism being connected to the second induction coil;
a second induction coil moving mechanism, configured to drive the third induction coil to move along the axial direction of the crucible, the second induction coil driving mechanism being connected to the third induction coil.

13. The apparatus for crystal growth according to claim 10, wherein the apparatus further comprises a fourth induction coil and a fifth induction coil, the fourth induction coil being arranged below the second induction coil in the axial direction of the crucible;
the fifth induction coil is sleeved on an outside of the fourth induction coil, and the fifth induction coil is arranged below the third induction coil in the axial direction of the crucible.

14. The apparatus for crystal growth according to claim 1, wherein the apparatus further comprises a filtering structure arranged in the furnace chamber, the filtering structure being located above a material in the crucible in the axial direction of the crucible, wherein the filtering structure comprises through-holes penetrating the filtering structure from top to bottom along the axial direction of the crucible.

15. The apparatus for crystal growth according to claim 14, wherein a material of the filtering structure comprises graphite; or
the material of the filtering structure comprises one or more of tantalum, tungsten, titanium, and corresponding nitrides or carbides.

16. The apparatus for crystal growth according to claim 14, wherein an aperture size of a through-hole in an edge region of the filtering structure is smaller than an aperture size of a through-hole in a central region of the filtering structure, and a porosity of the through-hole in the edge region of the filtering structure is greater than a porosity of the through-hole in the central region of the filtering structure.

17. The apparatus for crystal growth according to claim 14, wherein a porosity of the filtering structure is within a range of 5%-40%.

18. The apparatus for crystal growth according to claim 1, wherein the furnace chamber comprises a plurality of chambers, and the apparatus for crystal growth includes a plurality of crucibles, the plurality of crucibles being respectively arranged in the plurality of chambers;
the apparatus for crystal growth further comprises a conveying mechanism, at least a part of the conveying mechanism being located in the furnace chamber, the plurality of chambers being arranged along a conveying direction of the conveying mechanism, and the conveying mechanism conveys the plurality of crucibles to move the plurality of crucibles between different chambers.

19. The apparatus for crystal growth according to claim 18, wherein the plurality of chambers form a first chamber, a second chamber, and a third chamber; the first chamber, the second chamber, and the third chamber are arranged along the conveying direction; a maximum temperature in the second chamber is higher than a maximum temperature in the first chamber, and the maximum temperature in the second chamber is higher than a maximum temperature in the third chamber; a maximum pressure in the second chamber is lower than a maximum pressure in the first chamber, and the maximum pressure in the second chamber is lower than a maximum pressure in the third chamber.

20. The apparatus for crystal growth according to claim 19, wherein a crystal growth process comprises a preheating stage, a crystal growth stage, and an annealing stage, crystal production of the crucible in the first chamber is in the preheating stage, crystal production in the crucible in the second chamber is in the crystal growth stage, and crystal production in the crucible in the third chamber is in the annealing stage.

21. The apparatus for crystal growth according to claim 18, wherein a passage and an openable partition are arranged between two adjacent chambers.

22. The apparatus for crystal growth according to claim 18, wherein the heating assembly comprises at least one sixth induction coil and at least one coil lifting device, the at least one sixth induction coil and the at least one coil lifting device being arranged in at least one of the chambers, each of the at least one coil lifting device being connected to one of the at least one sixth induction coil, and the coil lifting device being capable of lifting the sixth induction coil connected to the coil lifting device along the axial direction of the crucible.

23. The apparatus for crystal growth according to claim 18, wherein the apparatus further comprises a plurality of thermal insulation structures, the plurality of thermal insulation structures being arranged outside the plurality of crucibles in a one-to-one correspondence; each thermal insulation structure comprises a side insulating part and a top insulating part, and a temperature measuring opening is arranged on the top insulating part.

24. The apparatus for crystal growth according to claim 18, wherein the apparatus for crystal growth comprises a first temperature measuring assembly, the first temperature measuring assembly comprising a first electrical rail and a plurality of first thermometers, the plurality of first thermometers respectively measuring temperatures in inner cavities of the plurality of crucibles, the first electrical rail being arranged outside the crucibles, and a portion of each first thermometer of the plurality of first thermometers extending out of the crucible is in sliding electrical contact with the first electrical rail, the first electrical rail being parallel to the conveying direction of the conveying mechanism.

25. The apparatus for crystal growth according to claim 18, wherein the apparatus for crystal growth further comprises a plurality of third resistance heaters, each of the plurality of third resistance heaters being arranged in one of the plurality of chambers and located at a bottom portion of one of the plurality of crucibles, and the plurality of third resistance heaters being arranged below the conveying mechanism in an axial direction of the crucible.

26. The apparatus for crystal growth according to claim 1, wherein the apparatus further comprises a material preparation assembly, the material preparation assembly comprising a tunnel furnace and a plurality of raw material furnaces;
the tunnel furnace comprises a heating chamber and a movement driving mechanism, the plurality of raw material furnaces being sequentially arranged in the heating chamber along a length direction of the tunnel furnace, and the movement driving mechanism drives the plurality of raw material furnaces to move along the length direction of the tunnel furnace;
at least one fourth heating assembly is arranged in the heating chamber, and the at least one fourth heating assembly is configured to heat the raw material furnace.

27. The apparatus for crystal growth according to claim 26, wherein the tunnel furnace further comprises an insulating layer, the insulating layer insulating the heating chamber.

28. The apparatus for crystal growth according to claim 26, wherein the tunnel furnace further comprises a cooling mechanism, the cooling mechanism being arranged outside the heating chamber.

29. The apparatus for crystal growth according to claim 26, wherein the heating chamber sequentially comprises a preheating section, a heating section, and a cooling section that are separated from each other along the length direction of the tunnel furnace; a maximum temperature in the heating section is higher than a maximum temperature in the preheating section and a maximum temperature in the cooling section;
each of the preheating section, the heating section, and the cooling section is provided with a first temperature measuring mechanism and a first pressure measuring mechanism.

30. The apparatus for crystal growth according to claim 26, wherein the tunnel furnace comprises a second temperature measuring assembly, the second temperature measuring assembly being capable of measuring a temperature in each of the raw material furnaces.

31. The apparatus for crystal growth according to claim 30, wherein the second temperature measuring assembly comprises a second electrical rail and a plurality of second thermometers, each of the plurality of second thermometers measuring a temperature in one of the plurality of raw material furnaces, the second electrical rail being arranged outside the raw material furnaces, and a portion of each second thermometer of the plurality of second thermometers extending out of the raw material furnaces is in sliding electrical contact with the second electrical rail, the second electrical rail being parallel to the length direction of the tunnel furnace.

32. The apparatus for crystal growth according to claim 26, wherein the plurality of raw material furnaces are connected in sequence, and the movement driving mechanism comprises a push rod or a pull rod, the push rod or the pull rod being connected to one raw material furnace of the plurality of raw material furnaces.

33. The apparatus for crystal growth according to claim 26, wherein the apparatus further comprises at least one of a mixing chamber, a compacting chamber, or a pre-vacuum chamber.

34. The apparatus for crystal growth according to claim 33, wherein the mixing chamber comprises at least one of a pressure relief device or a weighing device.

35. The apparatus for crystal growth according to claim 26, wherein the raw material furnace comprises a main body of the raw material furnace and an upper cover, and a seed crystal bonding surface is arranged on the upper cover.

36. The apparatus for crystal growth according to claim 35, wherein a plurality of fourth heating assemblies are provided, each of the plurality of fourth heating assemblies being arranged around one of the plurality of raw material furnaces, and each raw material furnace is provided with a second temperature measuring mechanism and a second pressure measuring mechanism.

37. A method for crystal growth, **characterized by** using the apparatus for crystal growth according to claim 6, a crystal growth process comprising a crystal growth stage and an annealing stage, the method comprising:
during the crystal growth stage, heating the crucible by a first heating assembly and a second heating assembly;
during the annealing stage, heating the crucible by the second heating assembly and a third heating assembly.
